(19) Europäisches Patentamt
European Patent Office
Office européen des brevets

(11) **EP 4 503 068 A1**

(12) **EUROPEAN PATENT APPLICATION**
published in accordance with Art. 153(4) EPC

(43) Date of publication:
**05.02.2025 Bulletin 2025/06**

(21) Application number: **23779385.6**

(22) Date of filing: **09.03.2023**

(51) International Patent Classification (IPC):
**H01F 10/20** $^{(2006.01)}$     **C04B 35/26** $^{(2006.01)}$
**H05K 9/00** $^{(2006.01)}$

(52) Cooperative Patent Classification (CPC):
**C04B 35/26; H01F 10/20; H05K 9/00**

(86) International application number:
**PCT/JP2023/009083**

(87) International publication number:
**WO 2023/189359 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.03.2022 JP 2022058696**

(71) Applicant: **Powdertech Co., Ltd.**
**Kashiwa-shi, Chiba 277-8557 (JP)**

(72) Inventors:
• **ISHII, Kazutaka**
  **Kashiwa-shi, Chiba 277-8557 (JP)**
• **AGA, Koji**
  **Kashiwa-shi, Chiba 277-8557 (JP)**

(74) Representative: **Vossius & Partner**
**Patentanwälte Rechtsanwälte mbB**
**Siebertstrasse 3**
**81675 München (DE)**

(54) **MAGNETIC COMPOSITE**

(57) There is provided a magnetic composite including a ferrite layer and having excellent heat resistance, the ferrite layer being dense, having a relatively large film thickness, having an excellent effect of reducing magnetic loss at a high frequency, and having excellent adhesion. The magnetic composite includes a non-metallic inorganic base material and a ferrite layer provided on a surface of the non-metallic inorganic base material. The non-metallic inorganic base material has a thickness $(d_M)$ of 2.0 $\mu$m or more. In addition, the ferrite layer has a thickness $(d_F)$ of 2.0 $\mu$m or more and 50.0 $\mu$m or less, and contains spinel-type ferrite as a principal component. Further, a content of $\alpha$-Fe$_2$O$_3$ in the ferrite layer is 3.0 mass% or more and 25.0 mass% or less.

*FIG. 10*

**EP 4 503 068 A1**

## Description

TECHNICAL FIELD

The present invention relates to a magnetic composite.

BACKGROUND ART

With a rapid progress of electronic information and communication technology in recent years, utilization of electromagnetic waves is rapidly increasing, and frequency increasing and band widening of electromagnetic waves to be used have been advancing. Specifically, in addition to a system in a quasi-microwave band represented by mobile phones (1.5 GHz, 2.0 GHz) and a wireless LAN (2.45 GHz), introduction of a new system utilizing radio waves in an extremely high frequency band such as a high-speed wireless LAN (65 GHz) and a collision-prevention radar (76.5 GHz) is advancing.

As utilization extension and the frequency increasing of the electromagnetic waves are advanced, problems of electromagnetic interference such as malfunction of an electronic device and an adverse effect on a human body caused by electromagnetic noise are closed up, and there is an increasing demand for a countermeasure against EMC. As a method for the countermeasure against EMC, there is known a method of absorbing unnecessary electromagnetic waves using an electromagnetic wave absorber (radio wave absorber) to prevent intrusion of the electromagnetic waves.

For the electromagnetic wave absorber, a material exhibiting conductive loss, dielectric loss, and/or magnetic loss is used. As a material exhibiting magnetic loss, ferrite having high permeability and high electrical resistance is frequently used. The ferrite causes a resonance phenomenon at a specific frequency to absorb an electromagnetic wave, converts absorbed electromagnetic wave energy into thermal energy, and radiates the thermal energy to an outside. As an electromagnetic wave absorber using ferrite, a composite material or a ferrite thin film containing ferrite powder and a binder resin has been proposed. In addition, a technique of forming a ferrite film on a substrate is known in applications other than the electromagnetic wave absorber.

For example, Patent Literature 1 discloses that a coated metal sheet is prepared by applying a coating composition containing 20 mass% to 80 mass% of ferrite powder such as Mn-Zn ferrite, 3 mass% to 60 mass% of carbon black powder, and a resin as the remainder on at least one surface of a metal sheet (claims 1 to 6 in Patent Literature 1). In addition, Patent Literature 1 discloses that the coating composition has excellent heat dissipation and good electromagnetic wave absorption performance in a wide frequency band (paragraph [0060] in Patent Literature 1).

Patent Literature 2 discloses an electromagnetic wave absorber having a ferromagnetic material physically deposited on a substrate made of an organic macromolecule, and discloses that the electromagnetic wave absorber has good electromagnetic wave absorption properties, a small size, light weight, flexibility, and fastness (claim 1 and paragraph [0008] in Patent Literature 2). In addition, Patent Literature 2 discloses that an oxide-based soft magnetic material is mainly used as the ferromagnetic material, ferrite is preferable as the oxide-based soft magnetic material, and examples of physical vapor deposition include EB vapor deposition, ion plating, magnetron sputtering, and facing target type magnetron sputtering (paragraphs [0009], [0010], and [0017] in Patent Literature 2).

Patent Literature 3 discloses a composite magnetic film having an electromagnetic wave absorption function, which includes a magnetic phase constituting of a metal magnetic material and a high electrical resistance phase of highly insulating ferrite dispersed in an island shape in the magnetic phase (claim 1 in Patent Literature 3). In addition, Patent Literature 3 discloses that the composite magnetic film is formed by an aerosol deposition (AD) method in which raw material fine particle powder is aerosolized, and is caused to collide with a substrate or the like which is a material on which a film is to be formed to form a thick film, and that by applying the AD method, a composite magnetic film having a desired film thickness can be formed at a high speed (paragraphs [0029] and [0033] in Patent Literature 3).

Patent Literature 4 discloses an electromagnetic wave absorber that is a composite in which metal particles are dispersed in a ceramic parent phase such as ferrite (claims 1 and 8 in Patent Literature 4). In addition, Patent Literature 4 discloses that the electromagnetic wave absorber is often used by being formed on a substrate, and in this case, when a metal is the substrate, electromagnetic waves are reflected at an interface between the electromagnetic wave absorber and the substrate, and can be expected to be absorbed in the electromagnetic wave absorber again, and that a gas deposition method or an aerosol deposition method is used to manufacture the electromagnetic wave absorber (paragraphs [0029] and [0031] in Patent Literature 4).

As described above, in Patent Literatures 1 to 4, it is proposed to prepare an electromagnetic wave absorber by forming a ferrite-containing layer on a substrate such as a metal sheet. On the other hand, in applications other than the electromagnetic wave absorber, it has been proposed to form a ferrite-containing layer on a substrate. For example, Patent Literature 5 discloses an inductor element including a magnetic substrate, a coil formed on a surface of the magnetic substrate by a conductor, and a magnetic layer formed on the magnetic substrate by an aerosol deposition method so as to embed the coil (claim 1 in Patent Literature 5).

PRIOR ART DOCUMENTS

PATENT LITERATURES

Patent Literature 1: JP2004-027064A
Patent Literature 2: JP2005-045193A
Patent Literature 3: JP2007-088121A
Patent Literature 4: JP2007-180289A
Patent Literature 5: JP2007-250924A

SUMMARY OF INVENTION

OBJECT TO BE ACHIEVED BY THE INVENTION

Although it has been proposed to apply a composite prepared by forming a ferrite-containing layer on a substrate to applications of electronic devices including an electromagnetic wave absorber and an inductor, there is room for improvement in the conventional techniques. For example, a composite material containing the ferrite powder proposed in Patent Literature 1 is inferior in magnetic properties because the composite material contains a large amount of resin that is a nonmagnetic material. Therefore, there is a limit in enhancing electromagnetic wave absorption properties. Regarding the ferrite thin film proposed in Patent Literature 2, it is difficult to form the ferrite thin film to be thick in view of manufacture, and there is a limit in enhancing properties such as magnetic properties. In addition, even when a thick film can be formed, there is a problem that the film is easily peeled off from a base material. Since the composites proposed in Patent Literatures 3 and 4 include a highly conductive metal magnetic material, the complexes cannot be applied to applications requiring electrical insulation. Further, the element proposed in Patent Literature 5 also has a limit in enhancing properties such as electrical properties and adhesion.

The present inventors have conducted intensive studies in view of such problems. As a result, it was found that in the magnetic composite including the non-metallic inorganic base material and the ferrite layer, a crystalline state of the ferrite layer is important, and by controlling the crystalline state, a magnetic composite can be obtained which includes a ferrite layer and has excellent heat resistance, the ferrite layer being dense, having a relatively large film thickness, having an excellent effect of reducing magnetic loss at a high frequency, and having excellent adhesion.

The present invention has been completed based on such findings, and an object of the present invention is to provide a magnetic composite including a ferrite layer and having excellent heat resistance, the ferrite layer being dense, having a relatively large film thickness, having an excellent effect of reducing magnetic loss at a high frequency, and having excellent adhesion.

MEANS FOR ACHIEVING THE OBJECT

The present invention includes the following embodiments (1) to (8). In the present description, the expression "to" includes numerical values at both ends thereof. That is, "X to Y" has the same meaning as "X or more and Y or less".

(1) A magnetic composite including:

a non-metallic inorganic base material; and
a ferrite layer provided on a surface of the non-metallic inorganic base material, in which
the non-metallic inorganic base material has a thickness ($d_M$) of 2.0 $\mu$m or more,
the ferrite layer has a thickness ($d_F$) of 2.0 $\mu$m or more and 50.0 $\mu$m or less, and contains spinel-type ferrite as a principal component, and
a content of $\alpha$-$Fe_2O_3$ in the ferrite layer is 3.0 mass% or more and 25.0 mass% or less.

(2) The magnetic composite according to the above-mentioned (1), in which
in the ferrite layer, a ratio ($I_{222}/I_{311}$) of an integrated intensity ($I_{222}$) of a (222) plane to an integrated intensity ($I_{311}$) of a (311) plane in X-ray diffraction analysis is 0.00 or more and 0.03 or less.
(3) The magnetic composite according to the above-mentioned (1) or (2), in which
the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co).

(4) The magnetic composite according to any one of the above-mentioned (1) to (3), in which
in the ferrite layer, a ratio $(Ra/d_F)$ of an arithmetic average surface roughness (Ra) to the thickness $(d_F)$ is more than 0.00 and 0.20 or less.

(5) The magnetic composite according to any one of the above-mentioned (1) to (4), in which
the ferrite layer has a composition including a ferrite component and the remainder being inevitable impurities.

(6) The magnetic composite according to any one of the above-mentioned (1) to (5), in which
the non-metallic inorganic base material is made of an oxide.

(7) The magnetic composite according to any one of the above-mentioned (1) to (5), in which
the non-metallic inorganic base material is made of glass.

(8) An element or component having a coil and/or an inductor function, an electronic device, an electronic component accommodation housing, an electromagnetic wave absorber, an electromagnetic wave shield, or an element or component having an antenna function, which includes the magnetic composite according to any one of the above-mentioned (1) to (7).

EFFECTS OF INVENTION

According to the present invention, there is provided a magnetic composite including a ferrite layer and having excellent heat resistance, the ferrite layer being dense, having a relatively large film thickness, having an excellent effect of reducing magnetic loss at a high frequency, and having excellent adhesion.

BRIEF DESCRIPTION OF DRAWINGS

Fig. 1 illustrates an embodiment of a magnetic composite.
Fig. 2 illustrates another embodiment of the magnetic composite.
Fig. 3 illustrates yet another embodiment of the magnetic composite.
Fig. 4 illustrates an example in which the magnetic composite is applied to an inductor.
Fig. 5 illustrates an example in which the magnetic composite is applied to an LC filter.
Fig. 6 illustrates another example in which the magnetic composite is applied to an inductor.
Fig. 7 illustrates an example in which the magnetic composite is applied to a magnetic sensor.
Fig. 8 illustrates an example in which the magnetic composite is applied to an electromagnetic wave absorber.
Fig. 9 illustrates an example in which the magnetic composite is applied to an electronic component accommodation housing.
Fig. 10 illustrates an example of a configuration of an aerosol deposition film forming device.
Fig. 11 illustrates cross-sectional elemental mapping images of a ferrite layer obtained in Example 1.
Fig. 12 illustrates cross-sectional elemental mapping images of a ferrite layer obtained in Example 4.

EMBODIMENTS FOR CARRYING OUT THE INVENTION

Specific embodiments of the present invention (hereinafter, referred to as "the present embodiment") will be described. The present invention is not limited to the following embodiments, and various modifications can be made without departing from the gist of the present invention.

«1. Magnetic Composite»

The magnetic composite of the present embodiment includes a non-metallic inorganic base material and a ferrite layer provided on a surface of the non-metallic inorganic base material. The non-metallic inorganic base material has a thickness $(d_M)$ of 2.0 $\mu$m or more. The ferrite layer has a thickness $(d_F)$ of 2.0 $\mu$m or more and 50.0 $\mu$m or less, and contains spinel-type ferrite as a principal component. In addition, a content of $\alpha$-$Fe_2O_3$ in the ferrite layer is 3.0 mass% or more and 25.0 mass% or less. The magnetic composite will be described in detail below.

The non-metallic inorganic base material (which may be simply referred to as "base material") is formed of an inorganic material other than metal, and functions as a support of the magnetic composite. A shape of the base material is not particularly limited as long as the base material functions as a support. For example, the shape may be a plate shape, a foil shape, a rod shape, a box shape, a yarn shape, or a strip shape. A material of the base material is not particularly limited as long as the base material is made of an inorganic material other than metal. The base material may be made of an oxide or glass. Alternatively, the base material may be made of a nitride, a carbide, and/or a semiconductor material. The material of the base material may be any of a single crystal material, a polycrystalline material, and an amorphous material. In addition, the base material may be a single layer or a laminate.

When the base material is formed of an oxide, characteristics of the oxide can be reflected in the magnetic composite. For example, when a highly insulating material such as alumina is used as the base material, a magnetic composite having highly insulating characteristics can be prepared. When a material having high thermal conductivity such as sapphire is used as the base material, a magnetic composite having excellent thermal conductivity and heat dissipation can be prepared. By using such a material, the insulativity and the thermal conductivity of the magnetic composite can be enhanced. The base material is particularly preferably an alumina substrate.

When the base material is formed of an oxide, the base material may or may not contain iron (Fe). A material containing no iron (Fe) is preferably a dielectric material such as alumina ($Al_2O_3$), titanium oxide ($TiO_2$), barium titanate ($BaTiO_3$), or strontium titanate ($SrTiO_3$), or a material having a high volume resistance such as zirconium oxide ($ZrO_2$) or artificial sapphire. A material containing iron (Fe) is preferably a magnetic material having characteristics in magnetic properties, optical and magnetic properties, and/or electrical properties, for example, various kinds of ferrites and iron oxides.

When the base material is formed of a semiconductor material, a Si substrate, a GaN substrate, or a SiC substrate is preferable. When the base material is formed of glass, a base material made of quartz glass, soda glass, or borosilicate silicate glass is preferable.

The thickness ($d_M$) of the non-metallic inorganic base material is limited to 2.0 $\mu$m or more. When the base material is excessively thin, it is difficult to impart sufficient strength to the magnetic composite. In other words, in order to stably maintain the shape of the magnetic composite, it is desirable that the magnetic composite be as thick as the ferrite layer formed on the base material. Therefore, the thickness of the base material is preferably 2.0 $\mu$m or more, more preferably 10 $\mu$m or more, still more preferably 50 $\mu$m or more, and particularly preferably 100 $\mu$m or more. On the other hand, an upper limit of the thickness is not limited. However, by appropriately thinning the base material, it is possible to reduce the size and weight of the magnetic composite. The thickness may be 5,000 $\mu$m or less, 1,000 $\mu$m or less, 500 $\mu$m or less, 200 $\mu$m or less, 100 $\mu$m or less, or 50 $\mu$m or less. In addition, the base material may have a yarn shape, a strip shape, and a plate shape, or may have a sheet shape. However, the base material preferably has a sheet shape. A surface shape of the base material is not limited. The surface shape may be a planar shape or a curved shape.

Thermal diffusivity of the non-metallic inorganic base material is preferably 5 $\times$ 10$^{-6}$ m$^2$/s or more, and more preferably 10 $\times$ 10$^{-6}$ m$^2$/s. An upper limit of the thermal diffusivity is preferably high. However, in an embodiment in which a magnetic composite material is provided in contact with another member, when thermal conductivity or thermal diffusivity of the another member is low, heat may not be radiated even when the thermal diffusivity of the non-metallic inorganic base material is high. Therefore, an excessively high thermal diffusivity is not necessary. The thermal diffusivity of the non-metallic inorganic base material is preferably 15,000 $\times$ 10$^{-6}$ m$^2$/s or less, more preferably 5,000 $\times$ 10$^{-6}$ m$^2$/s or less, and most preferably 2,000 $\times$ 10$^{-6}$ m$^2$/s.

The ferrite layer of the present embodiment is a polycrystalline material containing spinel-type ferrite as a principal component. That is, the ferrite layer is an aggregate of crystal grains constituting of the spinel-type ferrite. The spinel-type ferrite is a composite oxide of iron (Fe) having a spinel-type crystal structure, most of which exhibit soft magnetism. By including the layer containing the spinel-type ferrite as the principal component, the magnetic composite has excellent magnetic properties. A type of the spinel-type ferrite is not particularly limited. Examples thereof include at least one selected from the group consisting of manganese (Mn) ferrite, zinc (Zn) ferrite, manganese-zinc (Mn-Zn) ferrite, magnesium (Mg) ferrite, magnesium-zinc (Mg-Zn) ferrite, nickel (Ni) ferrite, nickel-copper (Ni-Cu) ferrite, nickel-copper-zinc (Ni-Cu-Zn) ferrite, cobalt (Co) ferrite, and cobalt-zinc (Co-Zn) ferrite. In the present description, the principal component refers to a component having a content of 50.0 mass% or more. In order to utilize the excellent magnetic properties of the spinel-type ferrite, a content ratio of the spinel-type ferrite (ferrite phase) in the ferrite layer is preferably 60.0 mass% or more, more preferably 70.0 mass% or more, still more preferably 80.0 mass% or more, and particularly preferably 90.0 mass% or more.

The thickness ($d_F$) of the ferrite layer of the present embodiment is limited to 2.0 $\mu$m or more and 50.0 $\mu$m or less. When the ferrite layer is excessively thin, a film thickness of the ferrite layer becomes non-uniform, and there is a concern that the magnetic properties and electrical properties (electrical insulation) deteriorate. The thickness is preferably 3.0 $\mu$m or more, and more preferably 4.0 $\mu$m or more. However, it is difficult to form a film of an excessively thick ferrite layer while maintaining density thereof. In addition, when the ferrite layer is excessively thick, an internal stress of the ferrite layer becomes excessively large, and there is a concern that a problem such as peeling off of the ferrite layer or cracking of the base material may occur. Further, in order to reduce the size and weight of the magnetic composite, it is desirable that the ferrite layer be appropriately thin. The thickness is preferably 50.0 $\mu$m or less, more preferably 30.0 $\mu$m or less, still more preferably 20.0 $\mu$m or less, and particularly preferably 10.0 $\mu$m or less. When ferrite layers are provided on both surfaces of the base material, a thickness of the ferrite layer on one surface corresponds to $d_F$.

In the ferrite layer, a ratio ($I_{222}/I_{311}$) of an integrated intensity ($I_{222}$) of a (222) plane to an integrated intensity ($I_{311}$) of a (311) plane in X-ray diffraction (XRD) analysis is 0.00 or more and 0.03 or less ($0.00 \leq I_{222}/I_{311} < 0.03$). That is, when the ferrite layer is analyzed by an X-ray diffraction method, it is desirable that a diffraction peak based on the (222) plane of a spinel phase is hardly observed in an X-ray diffraction profile. This is because the crystal grains constituting the ferrite layer are constituted of microcrystals. The crystal grains of the ferrite layer of the present embodiment undergo plastic deformation during manufacture of the magnetic composite. Therefore, a crystallite diameter is small, and distribution of lattice constants is wide. As a result, the XRD peak becomes broad, and the (222) diffraction peak tends not to be observed. $I_{222}/I_{311}$ is more preferably 0.02 or less, and still more preferably 0.01 or less. In contrast, a common spinel-type ferrite material has high crystallinity even in a polycrystalline state. Therefore, the (222) plane diffraction peak is relatively strongly observed. Specifically, an XRD peak intensity ratio ($I_{222}/I_{311}$) is about 0.04 to 0.05 (4% to 5%).

A ferrite layer having a small XRD peak intensity ratio ($I_{222}/I_{311}$) is characterized by being dense. This is because the crystal grains undergone the plastic deformation are easily densely packed. In addition, such a ferrite layer has an effect of being excellent in adhesion to the base material. This is because a contact area with the base material is increased by the plastic deformation of the crystal grains. In addition, it is considered that the reason also includes that bonding to a material constituting the base material becomes strong due to the small crystallite diameter and a crystal structure in which the periodicity is disturbed. Further, such a ferrite layer is characterized by having a small magnetic loss (tan$\delta$) in a high-frequency region of 500 MHz or more. It is presumed that the reason is that a correlation length of a magnetic moment becomes short due to the small crystallite diameter, and as a result, a magnetic domain wall motion is smoothly performed in the high-frequency region. In contrast, in a common spinel-type ferrite material, the correlation length of the magnetic moment is considered to be long. Therefore, the magnetic domain wall motion by an external magnetic field can be performed in a low-frequency region, but in a high-frequency region of 100 MHz or more, the magnetic domain wall motion cannot follow fluctuation of the external magnetic field, and the magnetic loss increases.

Preferably, the crystallite diameter of the ferrite layer is 1 nm or more and 10 nm or less. By reducing the crystallite diameter to 10 nm or less, the density and the adhesion of the ferrite layer are further increased, and an effect of preventing an increase in magnetic loss is further remarkable. In addition, by setting the crystallite diameter to 1 nm or more, it is possible to prevent the ferrite layer from becoming amorphous and the magnetic properties from deteriorating. The crystallite diameter is more preferably 1 nm or more and 5 nm or less, and still more preferably 1 nm or more and 2 nm or less.

Preferably, a lattice constant of the spinel-type ferrite contained in the ferrite layer is 8.30 Å or more and 8.80 Å or less. By setting the lattice constant to 8.30 Å or more and 8.80 Å or less, an effect of enhancing magnetic properties of raw material grains can be obtained. The lattice constant is more preferably 8.30 Å or more and 8.60 Å or less, and still more preferably 8.30 Å or more and 8.50 Å or less.

Preferably, a ratio ($d_F/d_M$) of the thickness ($d_F$) of the ferrite layer to the thickness ($d_M$) of the non-metallic inorganic base material is 0.0004 or more and 1 or less ($0.0004 \leq d_F/d_M < 1$). When the thickness ratio ($d_F/d_M$) is excessively small, the film thickness of the ferrite layer becomes non-uniform, and the magnetic properties and the electrical properties (electrical insulation) deteriorate. The thickness ratio ($d_F/d_M$) is more preferably 0.004 or more. On the other hand, when the thickness ratio ($d_F/d_M$) is excessively large, the base material cannot resist the internal stress of the ferrite layer, and the composite may be curved or broken. The thickness ratio ($d_F/d_M$) is more preferably 0.1 or less, still more preferably 0.02 or less, particularly preferably 0.01 or less.

When the base material is uneven, an arithmetic average of the thinnest portion and the thickest portion of the base material on which the ferrite layer is formed is defined as the thickness $d_M$ of the base material, and a difference between an arithmetic average of the thinnest portion and the thickest portion of the composite and the thickness $d_M$ of the base material is defined as the thickness $d_F$ of the ferrite layer. When the thickness $d_M$ of the base material exceeds 5,000 $\mu$m, the thickness ratio ($d_F/d_M$) is calculated by regarding the thickness $d_M$ of the base material as 5,000 $\mu$m.

In the ferrite layer of the present embodiment, a content of $\alpha$-Fe$_2$O$_3$ (hematite) is 3.0 mass% or more and 25.0 mass% or less. $\alpha$-Fe$_2$O$_3$ is a free iron oxide that did not become a spinel phase. Unlike the spinel phase which is a ferromagnetic material, $\alpha$-Fe$_2$O$_3$ is an antiferromagnetic material. Therefore, when an amount of $\alpha$-Fe$_2$O$_3$ is excessively large, the magnetic properties of the ferrite layer may deteriorate. The amount of $\alpha$-Fe$_2$O$_3$ is more preferably 23.0 mass% or less, and still more preferably 21.0 mass% or less. Meanwhile, $\alpha$-Fe$_2$O$_3$ is a stable compound having high electrical resistance. By appropriately containing $\alpha$-Fe$_2$O$_3$ in the ferrite layer, a conductive path in the ferrite layer can be disconnected, and the electrical resistance can be further increased. In particular, the manganese (Mn) ferrite and the manganese-zinc (Mn-Zn) ferrite contain manganese (Mn) ions and iron (Fe) ions having unstable coefficients, and thus tend to have low electrical resistance. Accordingly, by containing $\alpha$-Fe$_2$O$_3$ in the ferrite, an effect of improving the electrical resistance can be remarkably exhibited. In addition, by appropriately containing $\alpha$-Fe$_2$O$_3$, densification of the ferrite layer and improvement in adhesion can be achieved. $\alpha$-Fe$_2$O$_3$ is generated in a film forming process of a ferrite layer during the manufacture of the magnetic composite. That is, the plastic deformation and reoxidation of the ferrite crystal grains occur when the film forming process is performed, and $\alpha$-Fe$_2$O$_3$ is generated. The plastic deformation and the reoxidation play an important role for densification of the ferrite layer and enhancement of the adhesion. Therefore, the ferrite layer containing an appropriate amount of $\alpha$-Fe$_2$O$_3$ has high density and adhesion. The amount of $\alpha$-Fe$_2$O$_3$ is preferably 3.0 mass% or more, more preferably 5.0 mass% or more, still more preferably 10.0 mass% or more, and particularly preferably 15.0 mass% or more.

Preferably, the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co). The elements contained in the ferrite layer can be confirmed using an analysis method and an analysis device such as ICP, EDX, SIMS, and XRF.

Preferably, in the ferrite layer, a ratio ($Ra/d_F$) of an arithmetic average surface roughness (Ra) to the thickness ($d_F$) is more than 0.00 and 0.20 or less ($0.00 < Ra/d_F < 0.20$). When the roughness ratio ($Ra/d_F$) is excessively large, the film thickness of the ferrite layer tends to be non-uniform. Therefore, an electric field is locally concentrated when a high voltage is applied, and a leakage current may be generated. The roughness ratio ($Ra/d_F$) is more preferably more than 0.00 and 0.10 or less, and still more preferably more than 0.00 and 0.05 or less.

The ferrite layer of the present embodiment has a relatively high density. The reason is that the ferrite crystal grains constituting the ferrite layer were repeatedly subjected to the plastic deformation, and as a result, small crystal grains were deposited so as to form the ferrite layer. A relative density of the ferrite layer is preferably 0.60 or more, more preferably 0.70 or more, still more preferably 0.80 or more, particularly preferably 0.90 or more. By increasing the density, an effect of improving the magnetic properties, the electrical properties, and the adhesion of the ferrite layer becomes more remarkable.

The ferrite layer of the present embodiment has a relatively high electrical resistance. The reason is that since the density of the ferrite layer is high, adsorption of a conductive component such as moisture which causes deterioration in electrical resistance is small. It is also considered that the small crystallite diameter of the ferrite crystal grains constituting the ferrite layer has an effect thereon. Actually, a common Mn-Zn ferrite material is considered to have relatively low electrical resistance, and a volume resistance thereof is about $10^4$ $\Omega \cdot$cm to $10^5$ $\Omega \cdot$cm. In contrast, the ferrite layer of the present embodiment exhibits a higher resistance value, and a cause thereof can be found in a size of the crystallite diameter. Further, by containing an appropriate amount of $\alpha$-Fe$_2$O$_3$, the electrical resistance of the ferrite layer can be further increased. A surface resistance of the ferrite layer is preferably $10^4$ $\Omega$ or more, more preferably $10^5$ $\Omega$ or more, and still more preferably $10^7$ $\Omega$ or more. By increasing the surface resistance, the insulativity of the ferrite layer can be made excellent, and in a case where the magnetic composite is applied to a device, problems such as generation of an eddy current can be prevented.

The ferrite layer preferably has a composition including a ferrite component and the remainder being inevitable impurities. That is, it is preferable that organic components and inorganic components other than the ferrite component are not contained in excess of an amount of the inevitable impurities. The ferrite layer of the present embodiment can be sufficiently dense without adding a resin component such as a binder or an inorganic additive component such as a sintering aid. By limiting a content of a nonmagnetic material to the minimum, excellent magnetic properties based on ferrite can be sufficiently utilized. The ferrite component is a component constituting the spinel-type ferrite as a principal component. For example, in a case where the ferrite layer contains manganese-zinc (Mn-Zn) ferrite as the principal component, the ferrite component includes iron (Fe), manganese (Mn), zinc (Zn), and oxygen (O). In a case where the ferrite layer contains nickel-copper-zinc (Ni-Cu-Zn) ferrite as the principal component, the ferrite component includes iron (Fe), nickel (Ni), copper (Cu), zinc (Zn), and oxygen (O). Further, the inevitable impurities are components that are inevitably mixed during manufacture, and a content thereof is typically 1,000 ppm or less. In particular, the ferrite layer preferably contains no metal component other than an oxide.

The magnetic composite is preferably manufactured by a method including: a process (preparation process) of preparing a non-metallic inorganic base material and spinel-type ferrite powder having an average particle diameter (D50) of 2.5 $\mu$m or more and 10.0 $\mu$m or less; and a process (film forming process) of forming a film of the ferrite powder on a surface of the non-metallic inorganic base material by an aerosol deposition method, in which a ratio (LCf/LCp) of a lattice constant (LCf) of a spinel phase contained in a ferrite layer to a lattice constant (LCp) of a spinel phase contained in the spinel-type ferrite powder is 0.95 or more and 1.05 or less ($0.95 \leq LCf/LCp \leq 1.05$).

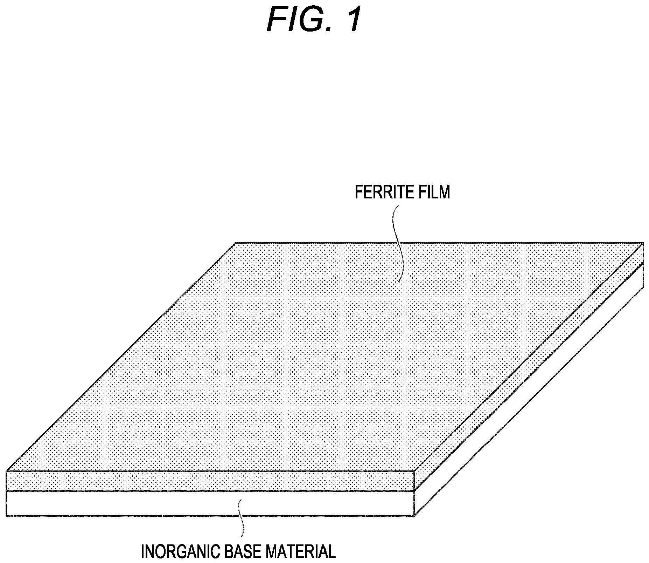

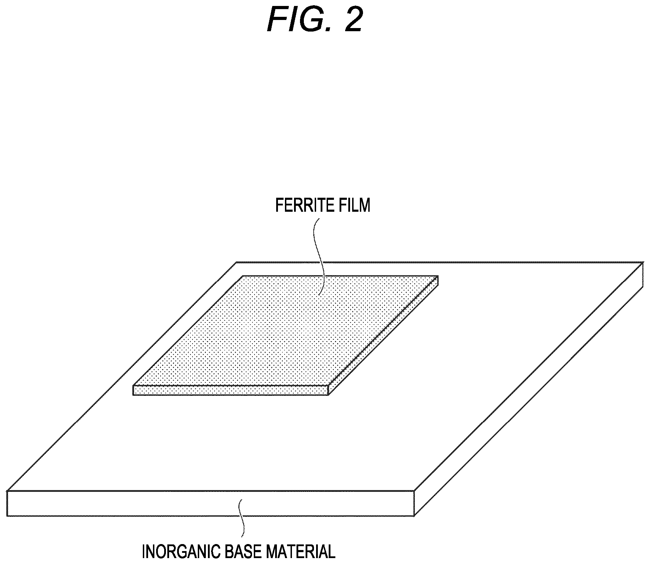

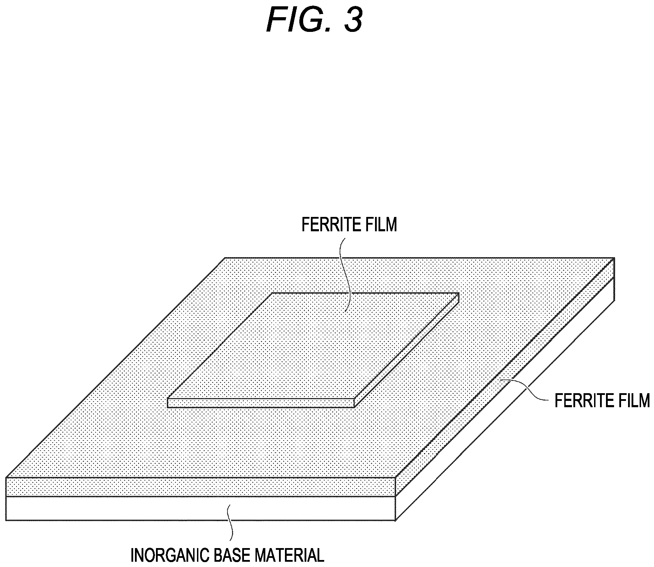

A form of the magnetic composite is also not particularly limited. As illustrated in Fig. 1, the ferrite layer (ferrite film) may be provided on the entire surface of the non-metallic inorganic base material. As illustrated in Fig. 2, the ferrite layer may be provided only on a part of the surface of the base material. The ferrite layer may be provided not only on one surface of the base material but also on both surfaces thereof. As illustrated in Fig. 3, a ferrite layer having a partially changed thickness may be provided on the surface of the base material.

The magnetic composite can be applied to various applications. Examples of such applications include an element or component having a coil and/or an inductor function, an electronic device, an electronic component accommodation housing, an electromagnetic wave absorber, an electromagnetic wave shield, or an element or component having an antenna function, which includes the magnetic composite.

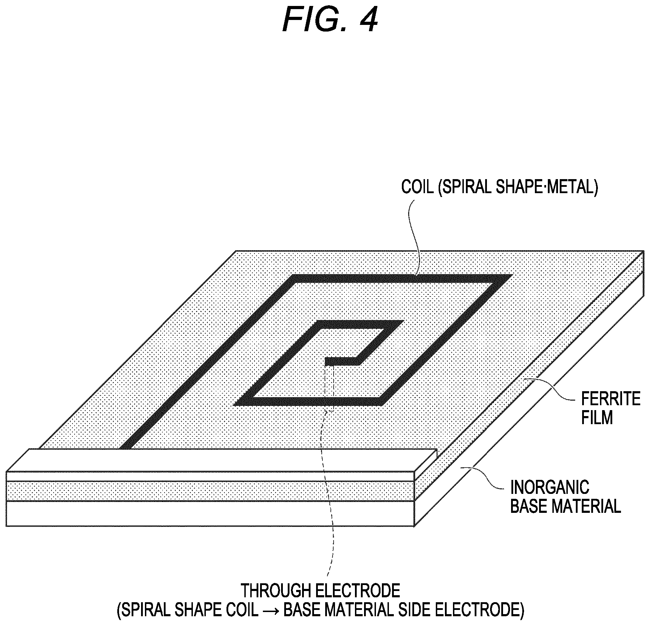

Fig. 4 illustrates an example in which the magnetic composite is applied to an inductor. The magnetic composite includes a non-metallic inorganic base material, a ferrite layer (ferrite film) provided on a surface of the base material, a coil layer provided on a surface of the ferrite layer, a base material side electrode provided on a back surface of the base material, and a through electrode connecting the coil layer and the base material side electrode. The base material may be determined according to the intended application. The coil layer is formed by a conductive material such as metal, and has a circuit pattern of a spiral shape. Therefore, an inductor function is exhibited. The circuit pattern of the coil may be formed by a method such as electroless plating, screen printing using a paste containing colloidal metal particles, ink jet, sputtering, or vapor deposition. By forming the circuit pattern on the ferrite layer, an element having a mild inductor function can be obtained.

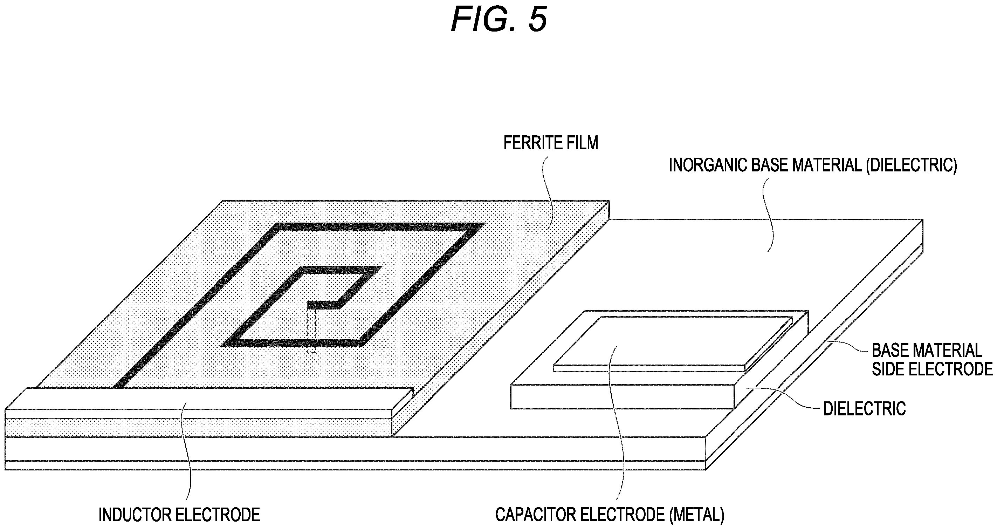

Fig. 5 illustrates an example in which the magnetic composite is applied to an LC filter. The magnetic composite includes a non-metallic inorganic base material, a ferrite layer (ferrite film) provided on a part of a surface of the base material, and a coil layer provided on a surface of the ferrite layer. On the other hand, a capacitor electrode is provided on the surface of the base material where the ferrite layer is not provided. In addition, a base material side electrode is provided on a back surface of the base material, and the base material sandwiched between the capacitor electrode and a base material type electrode functions as a dielectric. A portion where the ferrite layer is provided functions as an inductor element, and the base material (dielectric) sandwiched between the capacitor electrode and the base material side electrode functions as a capacitor element. Then, these operate as a whole LC filter.

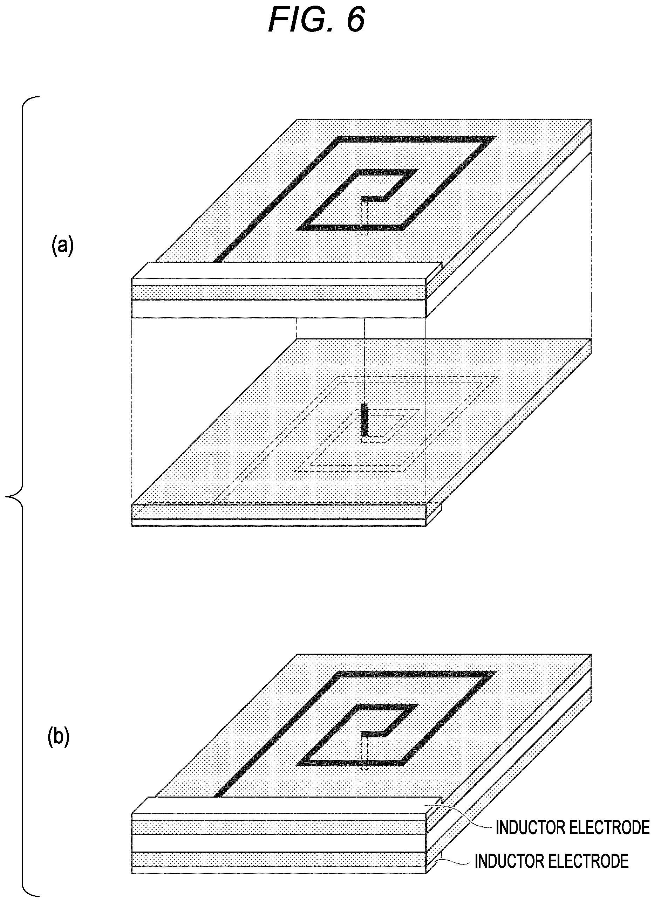

Fig. 6 illustrates another example in which the magnetic composite is applied to an inductor. In this example, ferrite layers (ferrite films) and coil layers are provided on both surfaces of the non-metallic inorganic base material. In addition, the coil layer on a front surface side and the coil layer on a back surface side are electrically connected to each other through a through electrode provided in the base material and the ferrite layers. By imparting an inductor function to both surfaces of the base material, it is possible to prepare a miniaturized inductor.

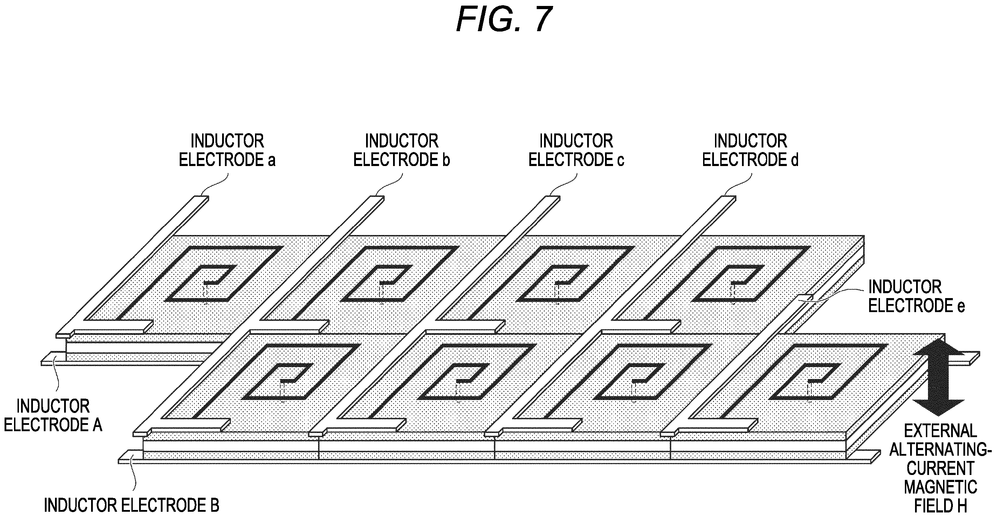

Fig. 7 illustrates an example in which the magnetic composite is applied to a magnetic sensor. In this example, inductor elements each having a ferrite layer (ferrite film) and a coil layer are arranged in an array on both surfaces of a non-metallic inorganic base material. During operation of the magnetic sensor, in a state where an external alternating-current magnetic field is applied, generated voltages are sequentially measured for each combination of lateral inductor electrodes A, B, and the like (lateral direction) disposed on a back surface of the base material and longitudinal inductor electrodes a, b, c, and the like disposed on a front surface of the base material. In a case where no magnetic material is present in the vicinity of the coil, inductances indicated by an inductor on the front surface and an inductor on the back surface of the base material are the same, so that no voltage is generated. In a case where a magnetic material is present, inductances of inductors in the vicinity of the magnetic material change, so that a voltage is generated. A position of the magnetic material can be detected based on a combination of the inductors in which the voltage is generated.

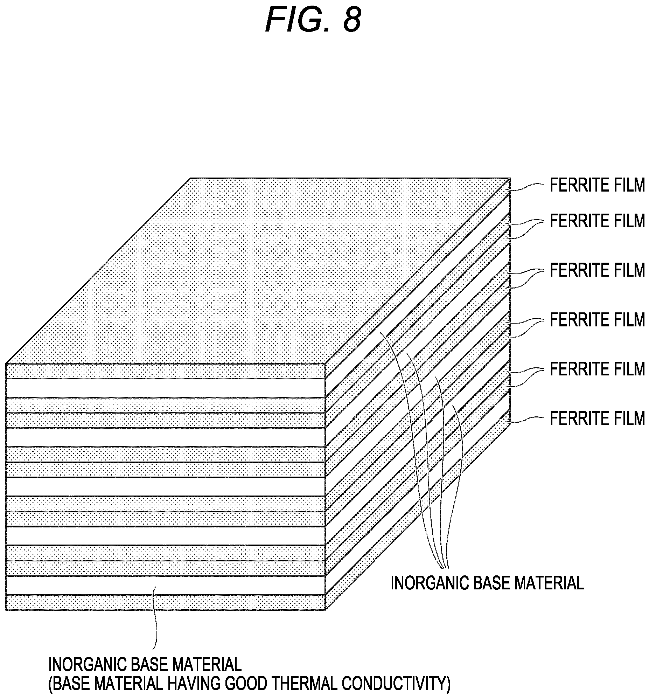

Fig. 8 illustrates an example in which the magnetic composite is applied to an electromagnetic wave absorber. The electromagnetic wave absorber (magnetic composite) has a structure in which non-metallic inorganic base materials and ferrite layers (ferrite films) provided on surfaces of the base materials are alternately laminated. In addition, the non-metallic inorganic base material on the lowermost surface is formed of a base material having excellent thermal conductivity.

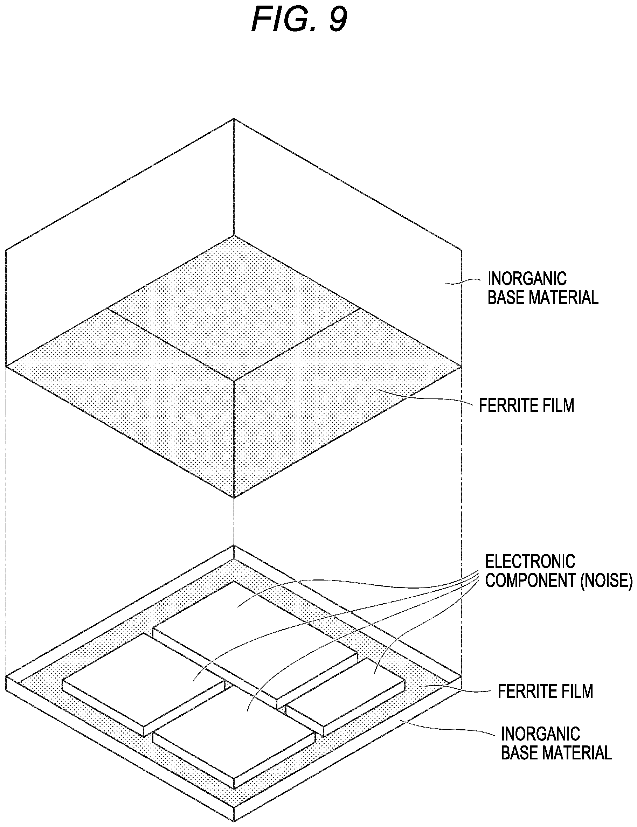

Fig. 9 illustrates an example in which the magnetic composite is applied to an electronic component accommodation housing. In this example, a ferrite layer (ferrite film) is provided on a surface of a non-metallic inorganic base material, and electronic components are mounted thereon. In addition, a ferrite layer is also provided on an inner surface side of a base material serving as a lid portion of the housing. By providing the ferrite layers having an electromagnetic wave shielding effect in the housing, it is possible to prevent unnecessary electromagnetic waves emitted from the electronic components from leaking to a surrounding environment.

«2. Manufacturing Method for Magnetic Composite»

A manufacturing method for the magnetic composite of the present embodiment is not limited as long as the above-described requirements are satisfied. However, a preferable manufacturing method includes the following processes; a process (preparation process) of preparing a non-metallic inorganic base material and spinel-type ferrite powder having an average particle diameter (D50) of 2.5 $\mu$m or more and 10.0 $\mu$m or less; and a process (film forming process) of forming a film of the ferrite powder on a surface of the non-metallic inorganic base material by an aerosol deposition method.

As described above, a relatively thick ferrite layer can be prepared at a high film forming rate by forming the film through the aerosol deposition method (AD method) using ferrite powder having a specific particle diameter as a raw material. The ferrite layer is dense, has excellent magnetic properties and electrical properties, and is excellent in adhesion to the base material. Therefore, the manufacturing method for the magnetic composite is suitable. Each process will be described in detail below.

<Preparation Process>

In the preparation process, the non-metallic inorganic base material and the spinel-type ferrite powder are prepared. Details of the base material are as described above. On the other hand, as the spinel-type ferrite powder, powder having an average particle diameter (D50) of 2.5 $\mu$m or more and 10.0 $\mu$m or less is prepared. An average particle diameter is preferably 2.5 μm or more and 9.0 μm or less, and more preferably 2.5 μm or more and 7.0 μm or less. By adjusting the average particle diameter within the above-mentioned range, a dense ferrite layer having high adhesion can be obtained in the subsequent film forming process.

A method for preparing the ferrite powder is not limited. However, it is preferable that a ferrite raw material mixture is subjected to sintering in an atmosphere having an oxygen concentration lower than that of the air to prepare a sintered product, and the obtained sintered product is pulverized to prepare particles having a specific particle diameter and an irregular shape. Before the sintering, the ferrite raw material mixture may be subjected to calcination, pulverization, and/or granulation treatment. As a ferrite raw material, a known ferrite raw material such as an oxide, a carbonate, and a hydroxide may be used.

A shape of the ferrite powder is preferably an irregular shape. Specifically, an average value of a shape factor (SF-2) of the ferrite powder is preferably 1.02 or more and 1.50 or less, more preferably 1.02 or more and 1.35 or less, and still more preferably 1.02 or more and 1.25 or less. Here, SF-2 is an index indicating a degree of irregularity of the particles, and the closer SF-2 is to 1, the more spherical the shape is, and the larger SF-2 is, the more irregular the shape is. When SF-2 is excessively small, the particles are excessively rounded. Therefore, biting of the particles to the base material becomes worse, and the film forming rate cannot be increased. On the other hand, when SF-2 is excessively large, unevenness of a particle surface becomes excessively large. Therefore, although the film forming rate is high, voids tend to remain in the obtained ferrite layer due to the unevenness of the particle surface. When SF-2 is within the above-mentioned range, a dense ferrite layer can be obtained at a high film forming rate. SF-2 is determined according to the following formula (1).

$$SF-2 = \left( \left( \frac{\left( \begin{array}{c} \text{PROJECTED PERIPHERAL} \\ \text{LENGTH OF PARTICLE} \end{array} \right)^2}{(\text{PROJECTED AREA OF PARTICLE})} \right) \div 4\pi \right) \quad \cdots (1)$$

An average value of an aspect ratio of the ferrite powder is preferably 1.00 or more and 2.00 or less, more preferably 1.20 or more and 1.85 or less, and still more preferably 1.40 or more and 1.70 or less. When the aspect ratio is within the above-mentioned range, a gas flow for supplying the raw material is stabilized during film formation. On the other hand, when the aspect ratio exceeds the above-mentioned range, the raw material is easily clogged in a pipe from a raw material supply container to a nozzle. Therefore, the film forming rate may become unstable with the elapse of a film forming time. The aspect ratio is obtained according to the following formula (2).

$$\text{ASPECT RATIO} = \frac{\text{MAJOR AXIS FERET DIAMETER}}{\text{MINOR AXIS FERET DIAMETER}} \quad \cdots (2)$$

Further, a CV value of the particle diameter of the ferrite powder is preferably 0.5 or more and 2.5 or less. Here, the CV value indicates a degree of variation in the particle diameter of the particles in the powder, and the CV value decreases as the particle diameter becomes more uniform, and increases as the particle diameter becomes more non-uniform. In a common pulverization method (bead mill, jet mill, or the like) for obtaining irregular particles, it is difficult to obtain powder having a CV value of less than 0.5. On the other hand, powder having a CV value of more than 2.5 is easily clogged in the pipe from the raw material supply container to the nozzle. Therefore, the film forming rate may become unstable with the elapse of a film forming time. The CV value is obtained according to the following formula (3) using a 10% cumulative diameter (D10), a 50% cumulative diameter (D50; average particle diameter), and a 90% cumulative diameter (D90) in volume particle size distribution.

$$\text{CV VALUE} = \frac{D90 - D10}{D50} \quad \cdots (3)$$

In a case where the calcination is performed at the time of preparing the ferrite powder, for example, the calcination may be performed under a condition of 500°C to 1,100°C × 1 hour to 24 hours in an air atmosphere. The sintering may be performed, for example, under a condition of 800°C to 1,350°C × 4 hours to 24 hours in an atmosphere such as the air or a reducing atmosphere. In addition, the oxygen concentration at the time of the sintering is preferably low.

As a result, a lattice defect can be intentionally generated in a spinel crystal of the ferrite powder. When the lattice defect is contained in the crystal, plastic deformation tends to occur from the lattice defect as a starting point when the raw material grains collide with the base material in the subsequent film forming process. Therefore, a dense ferrite layer having high adhesion can be easily obtained. The oxygen concentration is preferably 0.001 vol% to 10 vol%, more preferably 0.001 vol% to 5 vol%, and still more preferably 0.001 vol% to 2 vol%. When the ferrite contains copper (Cu), the sintering is preferably performed in an oxygen-present atmosphere other than the reducing atmosphere. Even when the sintering is performed in the oxygen-present atmosphere other than the reducing atmosphere, copper oxide (II) (CuO) releases a part of oxygen atoms and changes to copper oxide (I) ($Cu_2O$) due to an ionization tendency of copper. In this case, a lattice defect is easily generated. In addition, making the ferrite powder to have an iron (Fe)-rich composition is also effective for obtaining a dense ferrite layer.

Pulverization of the sintered product is preferably performed using a pulverizer such as a dry bead mill. By performing dry pulverization, the sintered product is subjected to a mechanochemical treatment, the crystallite diameter is reduced, and surface activity is increased. Pulverized powder having high surface activity contributes to densification of the ferrite layer obtained in the subsequent film forming process, along with an effect of an appropriate particle diameter. The crystallite diameter (CSp) of the ferrite powder is preferably 10 Å or more and 50 Å or less. By using ferrite powder having a fine crystallite diameter, a dense ferrite layer can be obtained.

<Film Forming Process>

In the film forming process (deposition process), the ferrite powder is formed into a film on the surface of the non-metallic inorganic base material by the aerosol deposition method. The aerosol deposition method (AD method) is a method in which aerosolized raw material fine particles are injected onto a substrate at a high speed to form a coating film by a room temperature impact solidification phenomenon. Since the room temperature impact solidification phenomenon is utilized, a dense film having high adhesion can be formed. In addition, since the fine particles are used as a supply raw material, a thick film can be obtained at a high film forming rate as compared with a thin film forming method such as a sputtering method or a vapor deposition method in which a raw material is separated to an atomic level. Further, since the film can be formed at room temperature, it is unnecessary to complicate a configuration of a device, and an effect of reducing manufacturing cost can also be obtained.

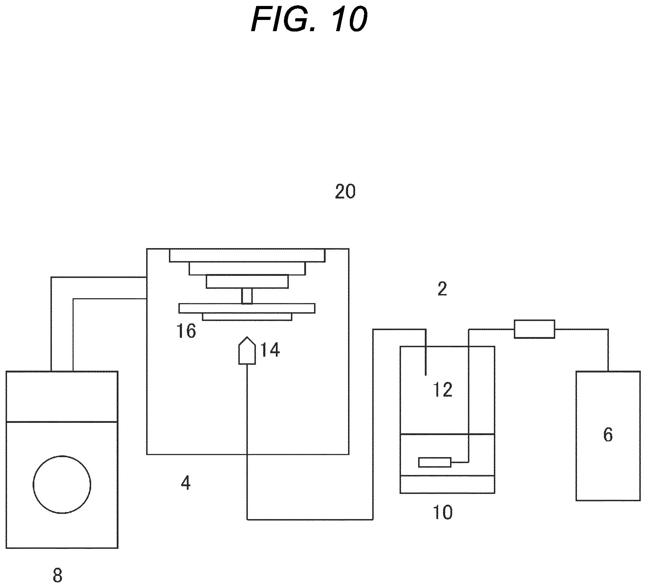

Fig. 10 illustrates an example of a configuration of an aerosol deposition film forming device. An aerosol deposition film forming device (20) includes an aerosolization chamber (2), a film formation chamber (4), a conveying gas source (6), and a vacuum evacuation system (8). The aerosolization chamber (2) includes a vibrator (10) and a raw material container (12) disposed thereon. A nozzle (14) and a stage (16) are provided inside the film formation chamber (4). The stage (16) is implemented to be movable perpendicularly to an injection direction of the nozzle (14).

In the film formation, a conveying gas is introduced from the conveying gas source (6) into the raw material container (12), and the vibrator (10) is caused to operate. Raw material fine particles (ferrite powder) are charged into the raw material container (12). The raw material fine particles are mixed with the conveying gas by vibration and subjected to aerosolization. In addition, the film formation chamber (4) is evacuated by the vacuum evacuation system (8) to depressurize the chamber. The aerosolized raw material fine particles are conveyed into the film formation chamber (4) by a pressure difference, and are injected from the nozzle (14). The injected raw material fine particles collide with a surface of a substrate (base material) placed on the stage (16) and are deposited thereon. In this case, in the raw material fine particles accelerated by gas conveyance, kinetic energy is locally released at the time of collision with the substrate, and bonding between the substrate and the particles and bonding between the particles are realized. Therefore, a dense film can be formed. By moving the stage (16) during the film formation, it is possible to form a coating film having a spread in a plane direction.

The reason why a dense ferrite layer can be obtained by the manufacturing method of the present embodiment is presumed as follows. That is, it is said that ceramic is usually a material having a high elastic limit and being hardly plastically deformed. However, it is considered that when the raw material fine particles collide with the substrate at a high speed during the film formation by an aerosol deposition method, an impact force is large to exceed the elastic limit, and thus the fine particles are plastically deformed. Specifically, defects such as crystal plane deviation and dislocation movement occur inside the fine particles, and in order to compensate for the defects, plastic deformation occurs and a crystal structure becomes fine. In addition, a newly generated surface is formed and movement of substances occurs. As a result of a combined effect of the above, it is considered that bonding forces between the substrate and the particles and between the particles are increased, and a dense film can be obtained. Further, it is considered that a part of ferrite is decomposed and reoxidized during the plastic deformation, and $\alpha$-$Fe_2O_3$ contributing to an increase in resistance is generated. In addition, it is also presumed that the fine particles colliding with the base material as a substrate in an initial stage of the film formation penetrate into the base material, and the penetrated fine particles develop an anchor effect, thereby increasing the adhesion between the ferrite layer and the base material.

In order to obtain a dense ferrite layer, the average particle diameter of the raw material ferrite powder is important. In the present embodiment, the average particle diameter (D50) of the ferrite powder is limited to 2.5 $\mu$m or more and 10.0 $\mu$m or less. When the average particle diameter is less than 2.5 $\mu$m, it is difficult to obtain a dense film. This is because powder having a small average particle diameter has a small mass of particles constituting the powder. The aerosolized raw material fine particles collide with the substrate at a high speed together with the conveying gas. The conveying gas colliding with the substrate changes its direction and flows as an exhaust gas. Particles having a small particle diameter and a small mass are washed away by an exhaust flow of the conveying gas, and a speed of collision with the surface of the substrate and an impact force caused by the collision are reduced. When the impact force is small, the plastic deformation that the fine particles undergo becomes insufficient, and the crystallite diameter is not reduced. The formed film does not become dense and becomes a compact in which the powder is only compressed. Such a compact includes a large number of voids therein, and is inferior in magnetic properties and electrical properties. In addition, the adhesion to the base material does not increase. On the other hand, when the average particle diameter is excessively large exceeding 10.0 $\mu$m, an impact force received by one particle is large, but the number of contact points between particles is reduced. Therefore, the plastic deformation and packing are insufficient, and it is difficult to obtain a dense film.

Film forming conditions according to the aerosol deposition method are not particularly limited as long as a dense ferrite layer having high adhesion can be obtained. Air or an inert gas (nitrogen, argon, helium, or the like) can be used as the conveying gas. However, an atmosphere that is easy to handle is preferable. A flow rate of the conveying gas may be, for example, 1.0 L/min to 20.0 L/min. In addition, an internal pressure of the film formation chamber may be, for example, 10 Pa to 50 Pa before the film formation and 50 Pa to 400 Pa in the middle of the film formation. A scanning speed (moving speed) of the non-metallic inorganic base material (stage) may be, for example, 1.0 mm/s to 10.0 mm/s. Coating (film formation) may be performed only once or may be performed a plurality of times. However, from a viewpoint of sufficiently ensuring the film thickness of the ferrite layer to be obtained, it is preferable to perform the coating a plurality of times. The number of times of coating is, for example, 5 times or more and 100 times or less.

The ratio (LCf/LCp) of the lattice constant (LCf) of the spinel phase contained in the ferrite layer to the lattice constant (LCp) of the spinel phase contained in the raw material ferrite powder is preferably 0.95 or more and 1.05 or less ($0.95 \leq$ LCf/LCp < 1.05). The spinel phase in the raw material ferrite powder has an oxygen-deficient composition and has lattice defects. Therefore, the lattice constant is larger than that in a state where no lattice defect exists. On the other hand, when the raw material ferrite powder is subjected to an aerosol deposition film forming treatment, plastic deformation from the lattice defects as a starting point occurs. In addition, an active surface is generated due to the plastic deformation, and the active surface is oxidized. Since reconstruction of the crystal structure and reoxidation of the active surface occur, the lattice constant changes. By controlling the lattice constant ratio (LCf/LCp) within the above-mentioned range, an amount of $\alpha$-Fe$_2$O$_3$ accompanying the reconstruction of the crystal structure and the reoxidation of the active surface can be adjusted within a desired range, and as a result, a ferrite layer having excellent electrical properties (electrical insulation) can be formed while maintaining excellent magnetic properties. The lattice constant ratio (LCf/LCp) is more preferably 0.99 or more and 1.04 or less.

A degree of change in the lattice constant varies depending on manufacturing conditions and a composition of the raw material ferrite powder as well as a material and a type of the base material. Specifically, when a ferrite composition is a stoichiometric composition or an iron (Fe)-rich composition (M$_x$Fe$_{3-x}$O$_4$: 0 < x $\leq$ 1, and M is a metal atom), an amount of oxygen contained in the raw material ferrite powder is likely to be substantially smaller than a stoichiometric ratio, depending on sintering conditions thereof. Therefore, the lattice constant of the raw material ferrite powder tends to increase. On the other hand, in the ferrite layer formed by the AD method, the crystal structure is reconstructed by oxidation accompanying the plastic deformation of the raw material grains, and thus the lattice constant tends to be smaller than that of the raw material ferrite powder. In particular, this tendency is remarkable in a case where ferrite powder containing lithium (Li) or manganese (Mn) or ferrite powder sintered at a lower oxygen concentration than the air is used. Therefore, in this case, LCf/LCp is likely to be less than 1.00.

When an amount of Fe is smaller than the stoichiometric ratio of the ferrite (M$_x$Fe$_{3-x}$O$_4$: 1 < x, and M is a metal atom), the amount of oxygen contained in the ferrite is about the same as the stoichiometric ratio. In addition, in the ferrite layer formed by the AD method, lattice defects due to the plastic deformation increase, and thus the lattice constant is likely to increase. In particular, this tendency is remarkable in a case where ferrite powder containing Cu or ferrite powder sintered in the air atmosphere is used. Therefore, in this case, LCf/LCp tends to exceed 1.00.

The lattice constant ratio (LCf/LCp) can also be adjusted by controlling conditions of the aerosol deposition film formation. That is, progress of strain and reoxidation can be promoted by increasing the collision speed of the raw material fine particles. The collision speed of the raw material fine particles can be changed by adjusting the internal pressure of the chamber or the like. In addition, excessive progress of reoxidation can be prevented by changing the film forming rate. This is because the reoxidation proceeds from the surface of the raw material fine particles, and thus the progress of the reoxidation is prevented when the film forming rate of the ferrite layer is increased to shorten an exposure time of the raw material fine particles to the air.

A ratio (CSf/CSp) of a crystallite diameter (CSf) of the spinel phase contained in the ferrite layer to a crystallite diameter (CSp) of the spinel phase contained in the raw material ferrite powder is preferably 0.01 or more and 0.50 or less (0.01 ≤ CSf/CSp < 0.50). The crystallite diameter of the ferrite changes through the aerosol deposition film formation. This is because strain occurs at the time of collision with the base material, and the active surface is reoxidized. Even when the film formation is performed under a condition that the crystallite diameter ratio (CSf/CSp) becomes excessively small, a dense ferrite layer having high adhesion cannot be obtained. This is because the internal stress of the ferrite layer becomes too large. In addition, even when the film formation could be performed, the ferrite layer is easily peeled off due to the internal stress. Therefore, stability over time is insufficient. The crystallite diameter ratio (CSf/CSp) is more preferably 0.05 or more and 0.30 or less, and still more preferably 0.10 or more and 0.20 or less.

In this way, the magnetic composite of the present embodiment can be obtained. In the obtained magnetic composite, since the ferrite layer is dense, the magnetic properties and the electrical properties (electrical insulation) thereof are excellent. In addition, the adhesion to the base material is high. Actually, the present inventors succeeded in preparing a magnetic composite including a ferrite layer having a relative density of 0.89 or more and adhesion of 10H in pencil hardness. Further, the ferrite layer has relatively small magnetic loss in a high-frequency region. In addition, although not limited, it is possible to reduce the size and weight of the magnetic composite by using a thinned base material. The magnetic composite including such a ferrite layer can be used not only for an electromagnetic wave absorber but also for an application of an electronic component such as a transformer, an inductance element, and an impedance element, and is particularly suitable for a UHF tag, a 5G filter, and a high-frequency inductor.

A technique for preparing such a magnetic composite of the present embodiment has not been known so far as the inventors know. For example, the composite material containing the ferrite powder proposed in Patent Literature 1 is inferior in magnetic properties because the composite material contains a large amount of resin that is nonmagnetic. In addition, regarding the ferrite thin film proposed in Patent Literature 2, it is difficult to form the ferrite thin film to be thick in view of manufacture. Further, since a composite magnetic material proposed in Patent Literature 3 includes a highly conductive metal magnetic material, the composite magnetic material cannot be applied to applications requiring electrical insulation. The magnetic composite of the present embodiment is also sufficiently applicable to applications in which a ferrite layer does not contain a resin or a metal component and electrical insulation is required.

Patent Literature 3 also discloses that the composite magnetic film is prepared by setting a content of iron powder (metal magnetic material) to 0% (paragraph [0048] in Patent Literature 3). However, a peak of the (222) plane is present in the X-ray diffraction profile (Fig. 3 in Patent Literature 3), and it is presumed that the ferrite layer in the magnetic film is not in a microcrystalline state and is inferior in denseness and adhesion. Patent Literature 3 discloses $\alpha$-$Fe_2O_3$ as a ferrite raw material together with Ni-Zn ferrite and Mn-Zn ferrite (paragraph [0036] in Patent Literature 3). However, Patent Literature 3 does not teach that a predetermined amount of $\alpha$-$Fe_2O_3$ is contained in the ferrite layer, and that by containing $\alpha$-$Fe_2O_3$, a conductive path in the ferrite layer is cut off and the electrical resistance increases. Actually, when $\alpha$-$Fe_2O_3$ is used as the raw material, coarse $\alpha$-$Fe_2O_3$ is contained in the ferrite layer, and this coarse $\alpha$-$Fe_2O_3$ prevents the magnetic domain wall motion of a ferrite component, resulting in deterioration of the magnetic properties.

EXAMPLES

The present invention will be described in more detail using the following examples. However, the present invention is not limited to the following examples.

(1) Preparation of Magnetic Composite

[Example 1]

In Example 1, ferrite powder containing Mn-Zn ferrite as a principal component was prepared, and the obtained ferrite powder was formed into a film on each of a front surface and a back surface of a glass substrate (non-metallic inorganic base material) having a thickness of 1,000 $\mu$m to prepare a magnetic composite. Preparation of the ferrite powder and film formation were performed by the following procedures.

<Preparation of Ferrite Powder>

As raw materials, iron oxide ($Fe_2O_3$), trimanganese tetraoxide ($Mn_3O_4$), and zinc oxide (ZnO) were used, and the raw materials were weighed and mixed such that a molar ratio of $Fe_2O_3$:$Mn_3O_4$:ZnO = 53:12.3:10. The mixing was performed using a Henschel mixer. The obtained mixture was molded using a roller compactor to obtain a granulated product (temporary granulated product).

Next, the granulated raw material mixture (temporary granulated product) was calcined to prepare a calcined product. The calcination was performed using a rotary kiln under a condition of 880°C × 2 hours in an air atmosphere.

Thereafter, the obtained calcined product was pulverized and granulated to prepare a granulated product. First, the calcined product was coarsely pulverized using a dry bead mill (steel beads of $\varphi$3/16 inches), and then water was added thereto, followed by fine pulverization using a wet bead mill (zirconia beads of φ0.65 mm) to obtain a slurry. A solid content concentration of the obtained slurry was 50 mass%, and a particle diameter (slurry particle diameter) of the pulverized powder was 2.15 μm. To the obtained slurry, a polycarboxylic acid ammonium salt was added as a dispersant at a ratio of 50 cc with respect to 25 kg of a solid content in the slurry, and a 10 mass% aqueous solution of polyvinyl alcohol (PVA) was further added as a binder at an addition amount of 500 cc. Thereafter, the slurry to which the dispersant and the binder were added was granulated using a spray dryer to obtain the granulated product.

Then, the obtained granulated product was sintered under a condition of 1,250°C × 4 hours in a non-oxidizing atmosphere using an electric furnace to prepare a sintered product. Next, the obtained sintered product was crushed using a hammer crusher, and further caused to pass through a dry bead mill (steel beads of φ3/16 inches) twice using the bead mill under conditions of a paddle circumferential speed of 6.5 m/s and a raw material supply amount of 5.0 kg/h to prepare a pulverized sintered product having a volume average particle diameter (D50) of 5.0 μm.

<Film Formation>

Film formation of a ferrite layer was performed on each of a front surface and a back surface of a non-metallic inorganic base material using the obtained pulverized sintered product. A glass substrate having a thickness of 1,000 μm was used as the base material. The film formation was performed according to the aerosol deposition (AD) method under the following conditions. Further, the film formation was performed 12 times for each of the front surface and the back surface of the base material, and the film formation was performed on the glass substrate under the same conditions such that two kinds of ferrite layers (ferrite films) having a toroidal shape and a rectangular shape were obtained.

- Carrier gas (conveying gas): air
- Gas flow rate: 2.5 L/min
- Internal pressure of film formation chamber (before film formation): 30 Pa
- Internal pressure of film formation chamber (during film formation): 100 Pa
- Substrate scanning speed: 6 mm/s
- Number of times of coating: 12 times + 12 times
- Distance from base material to nozzle: 20 mm
- Nozzle shape: 10 mm × 0.4 mm
- Film shape: toroidal shape, rectangular shape

[Example 2]

In Example 2, an alumina ($Al_2O_3$) substrate having a thickness of 635 μm was used as the inorganic base material. In addition, a film was formed on the alumina substrate under the same conditions such that two kinds of ferrite layers (ferrite films) having a toroidal shape and a rectangular shape were obtained. A magnetic composite was prepared in the same manner as in Example 1 except for the above.

[Example 3]

In Example 3, raw material powder (ferrite powder) containing Ni-Cu-Zn ferrite as a principal component was prepared, and then the obtained ferrite powder was formed into a film on each of a front surface and a back surface of a glass substrate (non-metallic inorganic base material) having a thickness of 1,000 μm to prepare a magnetic composite. Preparation of the ferrite powder and film formation were performed by the following procedures.

As raw materials, iron oxide ($Fe_2O_3$), zinc oxide (ZnO), nickel oxide (NiO), and copper oxide (CuO) were used, and the raw materials were weighed and mixed such that a molar ratio of $Fe_2O_3$:ZnO:NiO:CuO = 48.5:29.25:16:6.25. In addition, calcination was performed under a condition of 850°C × 2 hours in an air atmosphere, and sintering was performed under a condition of 1,100°C × 4 hours in an oxidizing atmosphere. Further, the film formation was performed 36 times on each of the front surface and the back surface of the base material. A magnetic composite was prepared in the same manner as in Example 1 except for the above.

[Example 4]

In Example 4, an alumina ($Al_2O_3$) substrate having a thickness of 635 μm was used as the inorganic base material. In addition, a film was formed on the alumina substrate under the same conditions such that two kinds of ferrite layers (ferrite films) having a toroidal shape and a rectangular shape were obtained. A magnetic composite was prepared in the same manner as in Example 3 except for the above.

[Example 5 (Comparative Example)]

In Example 5, a ferrite layer (ferrite-containing resin sheet) was prepared by a coating method. Specifically, ferrite powder was prepared in the same manner as in Example 1, and 80 parts by mass of the obtained ferrite powder was dispersed and mixed with 20 parts by mass of a photocurable resin. Thereafter, the obtained mixture was applied onto a PET film. The coating was performed using an applicator such that a coating film having a thickness of 50 $\mu$m was obtained. Next, the obtained coating film was cured with ultraviolet to prepare a magnetic sheet. The PET film was used to apply a ferrite-containing resin sheet (80 parts by mass of ferrite powder + 20 parts by mass of photocurable resin). After the ferrite-containing resin sheet was formed, the PET film was removed, and evaluation was performed using only the ferrite-containing resin sheet (resin composition).

[Example 6 (Comparative Example)]

In Example 6, a ferrite layer (ferrite-containing resin sheet) was prepared by a coating method. Specifically, ferrite powder was prepared in the same manner as in Example 3, and 80 parts by mass of the obtained ferrite powder was dispersed and mixed with 20 parts by weight of a photocurable resin. Thereafter, the obtained mixture was applied onto a PET film. The coating was performed using an applicator such that a coating film having a thickness of 50 $\mu$m was obtained. Next, the obtained coating film was cured with ultraviolet to prepare a magnetic sheet. The PET film was used to apply a ferrite-containing resin sheet (80 parts by mass of ferrite powder + 20 parts by mass of photocurable resin). After the ferrite-containing resin sheet was formed, the PET film was removed, and evaluation was performed using only the ferrite-containing resin sheet (resin composition).

[Example 7 (Comparative Example)]

In Example 7, powder containing Mn-Zn as a principal component was used in the same manner as in Example 1 to form a film by an aerosol deposition method, but when the sintered product was crushed and pulverized, the sintered product was caused to pass through a bead mill six times under conditions of a paddle circumferential speed of 8.0 m/s and a raw material supply amount of 3.5 kg/h to prepare a pulverized sintered product having a volume average particle diameter (D50) of 0.6 $\mu$m. In addition, the film formation was performed 30 times on each of the front surface and the back surface of the base material (glass substrate). A magnetic composite was prepared in the same manner as in Example 1 except for the above.

[Example 8 (Comparative Example)]

When the sintered product was crushed and pulverized, the sintered product was caused to pass through a bead mill once under conditions of a paddle circumferential speed of 5.0 m/s and a raw material supply amount of 6.0 kg/h to prepare a pulverized sintered product having a volume average particle diameter (D50) of 12.2 $\mu$m. A magnetic composite was prepared in the same manner as in Example 7 except for the above.

[Example 9 (Comparative Example)]

Instead of pulverizing the crushed sintered product, particle size adjustment for removing fine powder and coarse powder by air flow classification was performed to prepare a sintered product having a volume average particle diameter (D50) of 9.8 $\mu$m. A magnetic composite was prepared in the same manner as in Example 7 except for the above.

[Example 10 (Comparative Example)]

Film formation conditions of a ferrite layer were changed as shown in Table 2. A magnetic composite was prepared in the same manner as in Example 1 except for the above.

For Examples 1 to 10, manufacturing conditions of the ferrite powder and the magnetic composites are summarized in Table 1 and Table 2.

[Table 1]

Table 1 Manufacturing conditions of ferrite powder

| | Charge composition | | | | | | Calcination | | Granulation | | | | Sintering | | Post process |
|---|---|---|---|---|---|---|---|---|---|---|---|---|---|---|---|
| | $Fe_2O_3$ (mol) | $Mn_3O_4$ (mol) | MgO (mol) | ZnO (mol) | NiO (mol) | CuO (mol) | Temperature (°C) | Atmosphere | Slurry particle diameter (μm) | Binder amount (cc) | Dispersant amount (cc) | Slurry concentration (mass%) | Temperature (°C) | Atmosphere | |
| Example 1 | 53 | 12.3 | - | 10 | - | - | 880 | Air | 2.15 | 500 | 50 | 50 | 1250 | Non-oxidizing | Crushing + pulverization |
| Example 2 | 53 | 12.3 | - | 10 | - | - | 880 | Air | 2.15 | 500 | 50 | 50 | 1250 | Non-oxidizing | Crushing + pulverization |
| Example 3 | 48.5 | - | - | 29.25 | 16 | 6.25 | 850 | Air | 2.56 | 500 | 50 | 50 | 1100 | Oxidizing | Crushing + pulverization |
| Example 4 | 48.5 | - | - | 29.25 | 16 | 6.25 | 850 | Air | 2.56 | 500 | 50 | 50 | 1100 | Oxidizing | Crushing + pulverization |
| Example 5* | 53 | 12.3 | - | 10 | - | - | 880 | Air | 2.15 | 500 | 50 | 50 | 1250 | Non-oxidizing | Crushing + pulverization |
| Example 6* | 48.5 | - | - | 29.25 | 16 | 6.25 | 850 | Air | 2.56 | 500 | 50 | 50 | 1100 | Oxidizing | Crushing + pulverization |
| Example 7* | 53 | 12.3 | - | 10 | - | - | 880 | Air | 2.15 | 500 | 50 | 50 | 1250 | Non-oxidizing | Crushing + pulverization |
| Example 8* | 53 | 12.3 | - | 10 | - | - | 880 | Air | 2.15 | 500 | 50 | 50 | 1250 | Non-oxidizing | Crushing + pulverization |
| Example 9* | 53 | 12.3 | - | 10 | - | - | 880 | Air | 2.15 | 500 | 50 | 50 | 1250 | Non-oxidizing | Pulverization + classification |

| Table 1 Manufacturing conditions of ferrite powder | | | | | | | | | | | | | | | |
|---|---|---|---|---|---|---|---|---|---|---|---|---|---|---|---|
| | Charge composition | | | | | | Calcination | | Granulation | | | | Sintering | | Post process |
| | $Fe_2O_3$ (mol) | $Mn_3O_4$ (mol) | MgO (mol) | ZnO (mol) | NiO (mol) | CuO (mol) | Temperature (°C) | Atmosphere | Slurry particle diameter ($\mu$m) | Binder amount (cc) | Dispersant amount (cc) | Slurry concentration (mass%) | Temperature (°C) | Atmosphere | |
| Example 10 | 53 | 12.3 | - | 10 | - | - | 880 | Air | 2.15 | 500 | 50 | 50 | 1250 | Non-oxidizing | Crushing + pulverization |
| Note 1) "*" indicates a comparative example. | | | | | | | | | | | | | | | |

EP 4 503 068 A1

[Table 2]

| Table 2 Manufacturing conditions of magnetic composite | | | | | | | |
|---|---|---|---|---|---|---|---|
| | Aerosol deposition film formation | | | | | | |
| | Carrier gas | Gas flow rate (L/min) | Internal pressure of film formation chamber (Pa) | | Substrate scanning speed (mm/s) | Number of times of coating | |
| | | | Before film formation | During film formation | | Front surface | Back surface |
| Example 1 | Air | 2.5 | 30 | 100 | 6 | 12 | 12 |
| Example 2 | Air | 2.5 | 30 | 100 | 6 | 12 | 12 |
| Example 3 | Air | 2.5 | 30 | 100 | 6 | 36 | 36 |
| Example 4 | Air | 2.5 | 30 | 100 | 6 | 36 | 36 |
| Example 5* | - | - | - | - | - | - | - |
| Example 6* | - | - | - | - | - | - | - |
| Example 7* | Air | 2.5 | 30 | 100 | 6 | 30 | 30 |
| Example 8* | Air | 2.5 | 30 | 100 | 6 | 30 | 30 |
| Example 9* | Air | 2.5 | 30 | 100 | 6 | 30 | 30 |
| Example 10* | Air | 2.5 | 30 | 100 | 6 | 100 | 100 |
| Note 1) "*" indicates a comparative example. | | | | | | | |

(2) Evaluation

Evaluations on various properties of the ferrite powder, the non-metallic inorganic base material, and the magnetic composite in Examples 1 to 10 were made as follows.

<Particle Shape (Raw Material Powder)>

An average value of SF-2 and an average value of the aspect ratio of the ferrite powder were determined as follows. The ferrite powder was analyzed by using a particle image analyzer (Morphologi G3, manufactured by Spectris Plc.), and a projected peripheral length, a projected area, a major axis Feret diameter, and a minor axis Feret diameter were determined for 30,000 particles. The analysis was performed using an objective lens with a magnification of 20 times. Then, obtained data was used to calculate SF-2 and the aspect ratio for each particle according to the following formulae (1) and (2), and average values thereof were obtained.

$$SF-2 = \left(\left(\frac{\left(\begin{array}{c}\text{PROJECTED PERIPHERAL}\\\text{LENGTH OF PARTICLE}\end{array}\right)^2}{(\text{PROJECTED AREA OF PARTICLE})}\right) \div 4\pi\right) \quad \cdots (1)$$

$$\text{ASPECT RATIO} = \frac{\text{MAJOR AXIS FERET DIAMETER}}{\text{MINOR AXIS FERET DIAMETER}} \quad \cdots (2)$$

<Particle Size Distribution (Raw Material Powder)>

The particle size distribution of the ferrite powder was measured as follows. First, 0.1 g of a sample and 20 ml of water were placed in a 30 ml beaker, and two drops of sodium hexametaphosphate were added as a dispersant. Next, the mixture was dispersed using an ultrasonic homogenizer (UH-150 type, manufactured by SMT Co., Ltd.). In this case, an output level of the ultrasonic homogenizer was set to 4, and dispersion was performed for 20 seconds. Thereafter, bubbles generated on a surface of the beaker were removed, and the beaker was introduced into a laser diffraction type particle size distribution measuring device (SALD-7500nano, manufactured by Shimadzu Corporation) to perform the measurement. In this measurement, a 10% cumulative diameter (D10), a 50% cumulative diameter (D50; average particle diameter), and a 90% cumulative diameter (D90) in the volume particle size distribution were obtained. Measurement conditions were set to a pump speed of 7, an internal ultrasonic irradiation time of 30, and a refractive index of 1.70-050i. Then, D10, D50, and D90 were used to calculate a CV value according to the following formula (3).

$$CV\ VALUE = \frac{D90 - D10}{D50} \quad \cdots \quad (3)$$

<XRD (Raw Material Powder and Ferrite Layer)>

The ferrite powder and the ferrite layer of the magnetic composite were analyzed by an X-ray diffraction (XRD) method. Analysis conditions were as follows.

-X-ray diffraction device: X'pertMPD (including a high-speed detector) manufactured by PANalytical

-    Radiation source: Co-K$\alpha$
-    Tube voltage: 45 kV
-    Tube current: 40 mA
-    Scanning speed: 0.002°/s (continuous scanning)
-    Scanning range (2$\theta$): 15° to 90°

In an obtained X-ray diffraction profile, an integrated intensity ($I_{222}$) of a (222) plane diffraction peak of a spinel phase and an integrated intensity ($I_{311}$) of a (311) plane diffraction peak were obtained, and an XRD peak intensity ratio ($I_{222}/I_{311}$) was calculated. In addition, based on the X-ray diffraction profile, respective content ratios of the spinel phase and $\alpha$-$Fe_2O_3$ were obtained.

Further, the X-ray diffraction profile was subjected to Rietveld analysis to estimate lattice constants (LCp and LCf) of the spinel phase, and crystallite diameters (CSp and CSf) of the spinel phase were obtained according to Scherrer's formula. Then, a lattice constant change rate (LCf/LCp) and a crystallite diameter change rate (CSf/CSp) of the spinel phase before and after the film formation were calculated.

<Magnetic Properties (Raw Material Powder, Inorganic Base Material, and Magnetic Composite)>

The magnetic properties (saturation magnetization, residual magnetization, and coercivity) of the ferrite powder and the inorganic base material were measured as follows. First, a sample was packed in a cell having an inner diameter of 5 mm and a height of 2 mm, and set in a sample vibrating type magnetic measurement device (VSM-C7-10A, manufactured by Toei Industry Co., Ltd.). An applied magnetic field was applied and swept to 5 kOe, and then the applied magnetic field was decreased to draw a hysteresis curve. Based on data of the obtained curve, the saturation magnetization (as), the residual magnetization ($\sigma$r), and the coercivity (Hc) of the sample were obtained.

For the magnetic composite having the glass substrate (Example 1 and Example 3), a sample in which a ferrite layer was formed on a glass substrate having a diameter of 5 mm and a thickness of 1 mm (1,000 $\mu$m) was prepared. Then, this sample was packed in a sample cell, and saturation magnetization (as), residual magnetization ($\sigma$r), and coercivity (Hc) of the sample were determined in the same manner as in the above-described method. For the magnetic composite having the alumina substrate (Example 2 and Example 4), a sample in which a ferrite layer was formed on an alumina substrate having a diameter of 5 mm and a thickness of 0.635 mm (635 $\mu$m) was prepared. Then, this sample was packed in a sample cell, and saturation magnetization ($\sigma$s), residual magnetization ($\sigma$r), and coercivity (Hc) of the sample were determined in the same manner as in the above-described method.

<True Specific Gravity (Raw Material Powder)>

The true specific gravity of the raw material powder was measured by a gas substitution method in accordance with JIS Z8837:2018.

<Thickness and Element Distribution (Ferrite Layer)>

A cross section of the ferrite layer was observed using a field-emission scanning electron microscope (FE-SEM) to determine the thickness. Then, element mapping analysis for the cross section was performed using an energy dispersive X-ray spectrometer (EDX) attached to the microscope, and a mapping image was obtained.

<Density (Ferrite Layer)>

The density of the ferrite layer was measured as follows. First, a mass of a base material alone before the film of the ferrite layer was formed was measured. Next, a mass of the base material after the film of the ferrite layer was formed was measured, and a difference from the mass of the base material alone was calculated to obtain a mass of the ferrite layer. In addition, a film formation area and a film thickness of the ferrite layer were measured. The film thickness was determined by observing the cross section of the ferrite layer with a scanning electron microscope (SEM). Then, the density of the ferrite layer was calculated according to the following formula (4).

$$\text{DENSITY OF FERRITE LAYER (g/cm}^3) = \frac{\text{MASS OF FERRITE LAYER (g)}}{\text{FILM FORMATION AREA OF FERRITE LAYER (cm}^2) \times \text{THICKNESS (cm)}} \quad \cdots \quad (4)$$

<Surface Roughness (Ferrite Layer)>

An arithmetic average roughness (Ra) and a maximum height (Rz) of the surface of the ferrite layer were evaluated using a laser microscope (OPTELICS HYBRID, manufactured by Lasertec Corporation). For each sample, measurement was performed at 10 points, and an average value thereof was obtained. The measurement was performed in accordance with JIS B 0601-2001. In addition, a roughness ratio ($Ra/d_F$) was calculated based on the arithmetic average roughness (Ra) and the thickness ($d_F$) of the ferrite layer.

<Surface Resistance (Ferrite Layer)>

The surface resistance of the ferrite layer was measured using a resistivity meter (LorestaHP MCP-T410, manufactured by Mitsubishi Chemical Corporation).

<Permeability (Magnetic Composite)>

The permeability of the magnetic composite was measured by a microstripline complex permeability measuring method using a vector network analyzer (PNA N5222B, 10 MHz to 26.5 GHz, manufactured by Keysight) and a permeability measuring device (manufactured by KEYCOM Corporation). Specifically, the magnetic composite was cut out and was set in the permeability measuring device as a measurement sample. In this case, a sheet-shaped sample was cut into a length of 16 mm and a width of 5 mm for use. The sample having a toroidal shape was prepared by preparing a base material having an outer diameter of 6.75 mm and an inner diameter of 3.05 mm and forming a ferrite layer thereon. Next, a measurement frequency was swept on a logarithmic scale in a range of 100 MHz to 10 GHz. A real part $\mu'$ and an imaginary part $\mu''$ of complex permeability at a frequency of 1 GHz were determined, and a loss factor (tan$\delta$) was calculated according to the following formula (5).

$$\tan \delta = \frac{\mu''}{\mu'} \quad \cdots \quad (5)$$

<Adhesion (Magnetic Composite)>

The adhesion between the ferrite layer and the inorganic base material was evaluated by a pencil hardness test (pencil scratch test). The measurement was performed in accordance with old JIS K5400. In each test, scratching with a pencil having the same concentration mark was repeated five times. In this case, a tip of a pencil lead was polished every time the pencil was scratched. Pencil hardness increases in the order of 3B, 2B, B, HB, F, H, 2H, 3H, 4H, 5H, 6H, 7H, 8H, 9H, and 10H, and a higher hardness means better adhesion.

<Curie Point (Magnetic Composite)>

The Curie point (Tc) of the magnetic composite was measured using a sample vibrating type magnetic measurement device (VSM). In this case, for the sample having a sheet shape, a magnetic composite cut into a predetermined size (length: 8 mm, width: 6 mm) was placed in a measurement cell and set in the sample vibrating type magnetic measurement device (VSM-5 type, manufactured by Toei Industry Co., Ltd.). The sample was heated from room temperature to 500°C at a rate of 0.3°C/s in a state where a 10 kOe of applied magnetic field was applied, and the saturation magnetization during heating was measured. The Curie point was calculated based on a temperature dependence of the obtained saturation magnetization. For the magnetic composite having the glass substrate (Example 1 and Example 3), a sample in which a ferrite layer was formed on a glass substrate having a diameter of 5 mm and a thickness of 1 mm (1,000 $\mu$m) was prepared. Then, this sample was packed into a sample cell, and the Curie point of the sample was calculated in the same manner as in the above-described method. For the magnetic composite having the alumina substrate (Example 2 and Example 4), a sample in which a ferrite layer was formed on an alumina substrate having a diameter of 5 mm and a thickness of 0.635 mm (635 $\mu$m) was prepared. Then, this sample was packed into a sample cell, and the Curie point of the sample was calculated in the same manner as in the above-described method.

(3) Evaluation Results

For Examples 1 to 10, properties of the ferrite powder and properties of the base material are shown in Tables 3 and 4, respectively. In addition, properties of the magnetic composite are shown in Tables 5 and 6.

As shown in Table 3, in all of the ferrite powder used for the film formations in Examples 1 to 10, the content ratio of the spinel phase was as high as 95 mass% or more, and synthesis of the spinel-type ferrite sufficiently progressed. In addition, the XRD peak intensity ratio ($I_{222}/I_{311}$) was about 1.98% to 8.13%, which was comparable to that of a common spinel-type ferrite. Further, the average particle diameter (D50) was 0.6 $\mu$m to 12.2 $\mu$m, and the crystallite diameter was 8.621 nm to 32.331 nm.

As shown in Table 4, the non-metallic inorganic base materials used in Examples 1 to 4 and 7 to 10 had a saturation magnetization ($\sigma$s) of zero.

As shown in Tables 5 and 6, in the magnetic composites of Examples 1 to 4, the thickness (dF) of the ferrite layer was relatively large as 2.3 $\mu$m or more, and the XRD peak intensity ratio ($I_{222}/I_{311}$) was almost zero (0). In addition, the amount of $\alpha$-Fe$_2$O$_3$ was 18.6 mass% to 20.6 mass%, and the crystallite diameter was as small as 1.92 nm or less. Therefore, these samples had high relative density, adhesion, and surface resistance. Specifically, in Examples 1 to 4, the relative density was as high as 0.89 to 0.92. In addition, the pencil hardness was as high as 10H or more, and the result of the adhesion test was good. Further, an excellent composite having a low permeability imaginary part ($\mu$") and a low loss factor (tan$\delta$) and having a low loss was obtained. Further, since no resin component (organic component) was contained, the composite had measurable magnetic properties even under a high temperature up to the Curie point.

On the other hand, in Examples 5 and 6 prepared by the coating method, the permeability imaginary portion ($\mu$") and the loss factor (tan $\delta$) were large, and the loss was large at 500 MHz and 1 GHz. In addition, in Examples 5 and 6, since the binder resin was used when the magnetic composite was formed, the resin was decomposed when the Curie point was measured as the temperature was raised. Therefore, the form of the magnetic composite could not be maintained.

In Example 7 in which a film was formed through aerosol deposition using ferrite powder having a small particle diameter, a ferrite layer was slightly formed on the surface of the base material, but the raw material at the time of film formation was a compact. Therefore, film properties of the obtained ferrite layer were the same as those of the raw materials at the time of film formation. On the other hand, in Examples 8 and 9 in which ferrite powder having a large particle diameter was used, the surface of the base material was etched, but the ferrite layer was not formed. In Example 10, the thickness of the ferrite layer was the largest. However, immediately after the film formation (immediately after preparation of magnetic composite), the entire base material was broken due to internal stress. Therefore, the stability over time of the magnetic composite was insufficient.

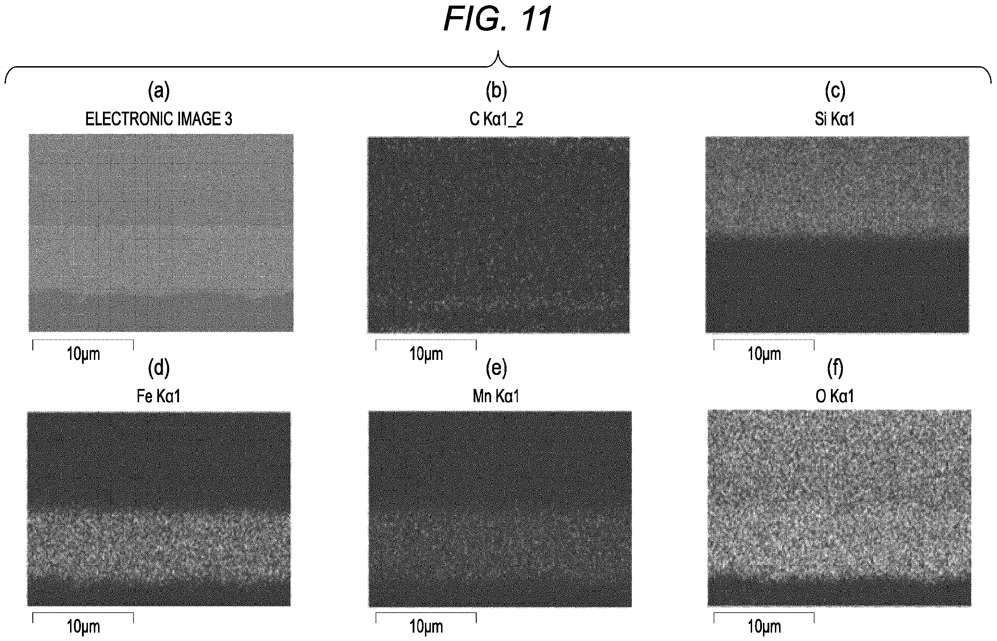

Cross-sectional elemental mapping images of the ferrite layer of the magnetic composite obtained in Example 1 are illustrated in (a) to (f) of Fig. 11. Here, (a) to (f) of Fig. 11 are an electron beam image (a), a carbon (C) mapping image (b), a silicon (Si) mapping image (c), an iron (Fe) mapping image (d), a manganese (Mn) mapping image (e), and an oxygen (O) mapping image (f), respectively. In addition, in (a) to (f) of Fig. 11, the non-metallic inorganic base material (glass substrate) is illustrated on an upper side, and the ferrite layer (Mn-Zn ferrite layer) is illustrated on a lower side.

Component elements of the non-metallic inorganic base material (glass substrate) and the ferrite layer (Mn-Zn ferrite layer) were clearly separated. That is, silicon (Si) was present on a base material side, and manganese (Mn), iron (Fe), and oxygen (O) were present only on a ferrite layer side. Based on the above, it was found that diffusion of elements due to a reaction did not occur between the base material and the ferrite layer. In addition, carbon (C) was not confirmed in either of the base material and the ferrite layer.

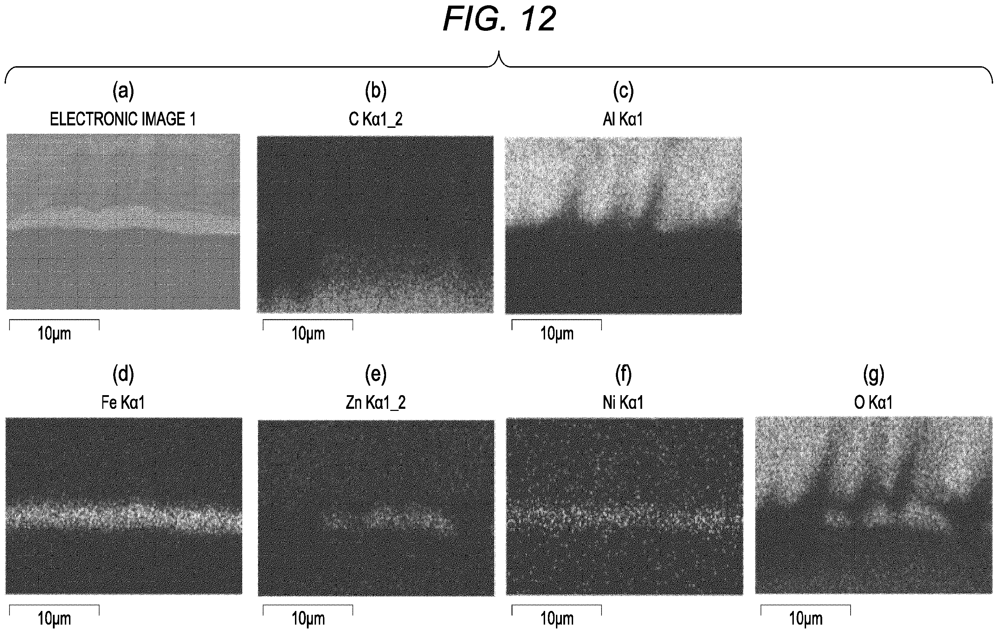

Cross-sectional elemental mapping images of the ferrite layer of the magnetic composite obtained in Example 4 are illustrated in (a) to (g) of Fig. 12. Here, (a) to (g) Fig. 12 are an electron beam image (a), a carbon (C) mapping image (b), an aluminum (Al) mapping image (c), an iron (Fe) mapping image (d), a zinc (Zn) mapping image (e), a nickel (Ni) mapping image (f), and an oxygen (O) mapping image (g), respectively. In addition, in (a) to (g) of Fig. 12, the non-metallic inorganic base material (alumina substrate) is illustrated on an upper side, and the ferrite layer (Ni-Cu-Zn ferrite layer) is illustrated on a lower side.

Component elements of the non-metallic inorganic base material (alumina substrate) and the ferrite layer (Ni-Cu-Zn ferrite layer) were clearly separated. That is, aluminum (Al) was present on the base material side, and nickel (Ni), copper (Cu), iron (Fe), zinc (Zn), and oxygen (O) were present only on the ferrite layer side. Based on the above, it was found that diffusion of elements due to a reaction did not occur between the base material and the ferrite layer. In addition, carbon (C) was not confirmed in either of the base material and the ferrite layer.

[Table 3]

Table 3 Properties of ferrite powder

| | Ferrite powder | | | | | | | | | | | | | |
| | Particle size distribution | | | SF-2 | Aspect ratio | True specific gravity (g/cm³) | Crystalline phase | | $I_{222}/I_{311}$ (%) | Lattice constant LCp (Å) | Crystallite diameter CSp (nm) | Magnetic properties (@5 kOe) | | |
| | D10 (μm) | D50 (μm) | D90 (μm) | | | | Spinel phase (mass%) | Fe₂O₃ (mass%) | | | | σs (emu/g) | σr (emu/g) | Hc (Oe) |
|---|---|---|---|---|---|---|---|---|---|---|---|---|---|---|
| Example 1 | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 2 | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 3 | 0.8 | 4.1 | 11.0 | 1.14 | 1.67 | 5.47 | 99.7 | 0.3 | 4.67 | 8.4043 | 16.682 | 57.3 | 4.0 | 57.2 |
| Example 4 | 0.8 | 4.1 | 11.0 | 1.14 | 1.67 | 5.47 | 99.7 | 0.3 | 4.67 | 8.4043 | 16.682 | 57.3 | 4.0 | 57.2 |
| Example 5* | 1.4 | 5.0 | 10.2 | 1.16 | 1.49 | 5.15 | 99.4 | 0.6 | 4.19 | 8.4950 | 16.025 | 85.6 | 4.2 | 50.6 |
| Example 6* | 0.8 | 4.1 | 11.0 | 1.14 | 1.67 | 5.47 | 99.7 | 0.3 | 4.67 | 8.4043 | 16.682 | 57.3 | 4.0 | 57.2 |
| Example 7* | 0.1 | 0.6 | 1.3 | 1.06 | 1.14 | 5.11 | 97.3 | 2.7 | 1.98 | 8.5123 | 8.621 | 77.8 | 6.3 | 90.2 |
| Example 8* | 4.3 | 12.2 | 18.1 | 1.29 | 2.04 | 5.16 | 99.9 | 0.1 | 5.11 | 8.4633 | 14.345 | 87.2 | 3.8 | 38.1 |
| Example 9* | 5.2 | 9.8 | 15.3 | 1.01 | 1.02 | 5.17 | 100.0 | 0.0 | 8.13 | 8.3997 | 32.331 | 88.9 | 3.1 | 28.9 |
| Example 10* | 1.4 | 5.0 | 10.2 | 1.16 | 1.49 | 5.15 | 99.4 | 0.6 | 4.19 | 8.4950 | 16.025 | 85.6 | 4.2 | 50.6 |
| Note 1) "*" indicates a comparative example. | | | | | | | | | | | | | | |

[Table 4]

| | Inorganic base material | | | | |
|---|---|---|---|---|---|
| | Material | Thickness $d_M$ ($\mu$m) | Magnetic properties | | Thermal diffusivity |
| | | | $\sigma$s (emu/g) | $\sigma$r (emu/g) | $\times 10^{-6}$ (m$^2$/s) |
| Example 1 | Glass | 1,000 | 0.0 | 0.0 | 500 |
| Example 2 | Alumina | 635 | 0.0 | 0.0 | 9,500 |
| Example 3 | Glass | 1,000 | 0.0 | 0.0 | 500 |
| Example 4 | Alumina | 635 | 0.0 | 0.0 | 9,500 |
| Example 5* | PET film note 2 | - | - | - | 150 |
| Example 6* | PET film note 2 | - | - | - | 150 |
| Example 7* | Glass | 1,000 | 0.0 | 0.0 | 500 |
| Example 8* | Glass | 1,000 | 0.0 | 0.0 | 500 |
| Example 9* | Glass | 1,000 | 0.0 | 0.0 | 500 |
| Example 10* | Glass | 1,000 | 0.0 | 0.0 | 500 |

Table 4 Properties of non-metallic inorganic base material

Note 1) "*" indicates a comparative example.
Note 2) The PET film was used for coating a ferrite layer (80 wt% of ferrite powder + 20 wt% of photocurable resin), and after the ferrite layer is formed, the PET film was removed, and evaluation was performed only on the ferrite layer.

[Table 5]

Table 5 Properties of magnetic composite

| | Thickness $d_F$ (µm) | | Thickness Ratio ($d_F/d_M$) | Density (g/cm³) | Relative density | Ra (µm) | Rz (µm) | Ra/$d_F$ | Composition (mass%) | | $I_{222}/I_{311}$ (%) | Lattice constant LCf (Å) | Crystallite diameter CSf (nm) | Lattice constant change rate LCf/LCp | Crystallite diameter change rate CSf/CSp | Surface resistance (0) |
|---|---|---|---|---|---|---|---|---|---|---|---|---|---|---|---|---|
| | Front surface | Back surface | | | | | | | Spinel phase | Fe$_2$O$_3$ | | | | | | |
| Example 1 | 6.5 | 6.5 | 0.006 | 4.76 | 0.92 | 0.144 | 0.895 | 0.022 | 81.4 | 18.6 | 0.004 | 8.4958 | 1.9118 | 1.0001 | 0.119 | $1.0 \times 10^5$ or less |
| Example 2 | 2.3 | 2.3 | 0.004 | 4.61 | 0.90 | 0.151 | 0.919 | 0.067 | 81.4 | 18.6 | 0.008 | 8.4956 | 1.9094 | 1.0001 | 0.119 | $1.0 \times 10^5$ or less |
| Example 3 | 6.8 | 6.8 | 0.007 | 4.81 | 0.90 | 0.139 | 0.886 | 0.020 | 79.4 | 20.6 | 0.002 | 8.4792 | 1.9052 | 1.0089 | 0.114 | $2.3 \times 10^7$ |
| Example 4 | 2.5 | 2.5 | 0.004 | 4.79 | 0.89 | 0.137 | 0.904 | 0.056 | 79.4 | 20.6 | 0.010 | 8.4779 | 1.8812 | 1.0088 | 0.113 | $2.3 \times 10^7$ |
| Example 5* | | | | 3.04 note 4 | Cannot be calculated | 0.346 | 1.981 | Cannot be calculate | 99.4 note 3 | 0.6 note 3 | 4.19 note 3 | 8.4950 note 3 | 16.0247 note 3 | 1.0000 | 1.000 | $1.0 \times 10^8$ or more |
| Example 6* | | | | 3.12 notea | Cannot be calculated | 0.411 | 2.089 | Cannot Be calculated | 99.7 note 3 | 0.3 note 3 | 4.67 note 3 | 8.4043 note 3 | 16.6815 note 3 | 1.0000 | 1.000 | $1.0 \times 10^8$ or more |
| Example 7* | < 0.1 note 5 | < 0.1 note 5 | Cannot be calculated notes 5 and 6 | | | | | | 97.3 note 5 | 2.7 note 5 | 1.98 note 5 | 8.5123 | 8.6210 | 1.0000 | 1.000 | $1.0 \times 10^8$ or more |
| Example 8* | | | | | | | | | | | | | | | | |
| Example 9* | | | | | | | | | | | | | | | | |

(continued)

| Table 5 Properties of magnetic composite | | | | | | | | | | | | | | | |
|---|---|---|---|---|---|---|---|---|---|---|---|---|---|---|---|
| | Thickness $d_F$ ($\mu$m) | | Thickness Ratio ($d_F/d_M$) | Density (g/cm$^3$) | Relative density | Ra ($\mu$m) | Rz ($\mu$m) | Ra/$d_F$ | Composition (mass%) | | $I_{222}/I_{311}$ (%) | Lattice constant LCf (Å) | Crystallite diameter CSf (nm) | Lattice constant change rate LCf/LCp | Crystallite diameter change rate CSf/CSp | Surface resistance (0) |
| | Front surface | Back surface | | | | | | | Spinel phase | Fe$_2$O$_3$ | | | | | | |
| Example 10* | 54.0 | 54.0 | The base material was broken hv a stress of the ferrite layer and evaluation could not be performed. | | | | | | | | | | | | |

Note 1) "*" indicates a comparative example.
Note 2) "-" indicates that measurement was not performed.
Note 3) XRD analysis results of a filler (ferrite) in a sheet-shaped resin molded article are shown.
Note 4) Values for the sheet-shaped resin molded article are shown.
Note 5) Results of measurement performed in a state where a compact was removed are shown.
Note 6) Calculation could not be performed because the formed film was not uniform.
Note 7) Calculation could not be performed because the ferrite layer was a mixture of a resin and ferrite powder and was not a pure ferrite layer.

[Table 6]

| Table 6 Properties of magnetic composite | | | | | | | | | | | | |
|---|---|---|---|---|---|---|---|---|---|---|---|---|
| | Magnetic properties | | | Shape of Permeability measurement sample | Permeability (500 MHz) | | | Permeability 1 GHz) | | | Adhesion | Curie point of ferrite layer (°C) |
| | σs (emu/g) | σr (emu/g) | Hc (Oe) | | μ' | μ" | tanδ | μ' | μ" | tanδ | Pencil hardness | |
| Example 1 | 1.1 | 0.1 | 147.9 | Toroidal shape | 2.31 | 0.17 | 0.07 | 2.61 | 0.48 | 0.18 | 10H or higher | 305 |
| Example 2 | 0.6 | 0.0 | 156.4 | Toroidal shape | 2.19 | 0.16 | 0.07 | 2.55 | 0.44 | 0.17 | 10H or higher | 305 |
| Example 3 | 0.8 | 0.1 | 247.5 | Toroidal shape | 2.15 | 0.09 | 0.04 | 1.97 | 0.16 | 0.08 | 10H or higher | 205 |
| Example 4 | 0.5 | 0.0 | 261.6 | Toroidal shape | 2.04 | 0.10 | 0.05 | 1.85 | 0.14 | 0.08 | 10H or higher | 205 |
| Example 5* | 69.3 | 3.4 | 50.9 | Sheet shape | 5.69 | 2.70 | 0.47 | 4.02 | 3.06 | 0.76 | - | Note 3 |
| Example 6* | 46.4 | 3.2 | 59.2 | Sheet shape | 3.64 | 1.33 | 0.37 | 2.85 | 1.62 | 0.57 | - | Note 3 |
| Example 7* | - | - | - | - | - | - | - | - | - | - | - | - |
| Example 8* | - | - | - | - | - | - | - | - | - | - | - | - |
| Example 9* | - | - | - | - | - | - | - | - | - | - | - | - |
| Example 10* | - | - | - | - | - | - | - | - | - | - | - | - |
| Note 1) "*" indicates a comparative example.<br>Note 2) "-" indicates that measurement was not performed.<br>Note 3) When the temperature exceeded 200°C, the resin was decomposed and could not be measured. | | | | | | | | | | | | |

EP 4 503 068 A1

**Claims**

1. A magnetic composite comprising:

   a non-metallic inorganic base material; and
   a ferrite layer provided on a surface of the non-metallic inorganic base material, wherein
   the non-metallic inorganic base material has a thickness ($d_M$) of 2.0 μm or more,
   the ferrite layer has a thickness ($d_F$) of 2.0 μm or more and 50.0 μm or less, and contains spinel-type ferrite as a principal component, and
   a content of $\alpha$-$Fe_2O_3$ in the ferrite layer is 3.0 mass% or more and 25.0 mass% or less.

2. The magnetic composite according to claim 1, wherein
   in the ferrite layer, a ratio ($I_{222}/I_{311}$) of an integrated intensity ($I_{222}$) of a (222) plane to an integrated intensity ($I_{311}$) of a (311) plane in X-ray diffraction analysis is 0.00 or more and 0.03 or less.

3. The magnetic composite according to claim 1 or 2, wherein
   the ferrite layer contains iron (Fe) and oxygen (O), and further contains at least one element selected from the group consisting of lithium (Li), magnesium (Mg), aluminum (Al), titanium (Ti), manganese (Mn), zinc (Zn), nickel (Ni), copper (Cu), and cobalt (Co).

4. The magnetic composite according to any one of claims 1 to 3, wherein
   in the ferrite layer, a ratio ($Ra/d_F$) of an arithmetic average surface roughness (Ra) to the thickness ($d_F$) is more than 0.00 and 0.20 or less.

5. The magnetic composite according to any one of claims 1 to 4, wherein
   the ferrite layer has a composition including a ferrite component and the remainder being inevitable impurities.

6. The magnetic composite according to any one of claims 1 to 5, wherein
   the non-metallic inorganic base material is made of an oxide.

7. The magnetic composite according to any one of claims 1 to 5, wherein
   the non-metallic inorganic base material is made of glass.

8. An element or component having a coil and/or an inductor function, an electronic device, an electronic component accommodation housing, an electromagnetic wave absorber, an electromagnetic wave shield, or an element or component having an antenna function, which comprises the magnetic composite according to any one of claims 1 to 7.

# FIG. 1

FERRITE FILM

INORGANIC BASE MATERIAL

# FIG. 2

FERRITE FILM

INORGANIC BASE MATERIAL

# FIG. 3

FERRITE FILM

FERRITE FILM

INORGANIC BASE MATERIAL

# FIG. 4

COIL (SPIRAL SHAPE·METAL)

FERRITE FILM

INORGANIC BASE MATERIAL

THROUGH ELECTRODE
(SPIRAL SHAPE COIL → BASE MATERIAL SIDE ELECTRODE)

## FIG. 5

FERRITE FILM

INORGANIC BASE MATERIAL (DIELECTRIC)

BASE MATERIAL SIDE ELECTRODE

DIELECTRIC

INDUCTOR ELECTRODE

CAPACITOR ELECTRODE (METAL)

EP 4 503 068 A1

# FIG. 6

(a)

(b)

INDUCTOR ELECTRODE
INDUCTOR ELECTRODE

FIG. 7

# FIG. 8

FERRITE FILM

FERRITE FILM

FERRITE FILM

FERRITE FILM

FERRITE FILM

FERRITE FILM

INORGANIC BASE MATERIAL

INORGANIC BASE MATERIAL
(BASE MATERIAL HAVING GOOD THERMAL CONDUCTIVITY)

# FIG. 9

INORGANIC
BASE MATERIAL

FERRITE FILM

ELECTRONIC
COMPONENT (NOISE)

FERRITE FILM

INORGANIC
BASE MATERIAL

# FIG. 10

*FIG. 11*

(a) ELECTRONIC IMAGE 3

(b) C Kα1_2

(c) Si Kα1

(d) Fe Kα1

(e) Mn Kα1

(f) O Kα1

10µm

## FIG. 12

(a)
ELECTRONIC IMAGE 1

10μm

(b)
C Kα1_2

10μm

(c)
Al Kα1

10μm

(d)
Fe Kα1

10μm

(e)
Zn Kα1_2

10μm

(f)
Ni Kα1

10μm

(g)
O Kα1

10μm

| INTERNATIONAL SEARCH REPORT | International application No. |
|---|---|
| | **PCT/JP2023/009083** |

**A.  CLASSIFICATION OF SUBJECT MATTER**

**H01F 10/20**(2006.01)i; **C04B 35/26**(2006.01)i; **H05K 9/00**(2006.01)i
FI:   H01F10/20; H05K9/00 M; C04B35/26

According to International Patent Classification (IPC) or to both national classification and IPC

**B.  FIELDS SEARCHED**

Minimum documentation searched (classification system followed by classification symbols)

H01F10/20; C04B35/26; H05K9/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| Y | JP 2007-174462 A (FUJIKURA LTD.) 05 July 2007 (2007-07-05)<br>paragraphs [0011]-[0018], [0030], [0035]-[0042], fig. 1 | 1-8 |
| Y | JP 2003-297628 A (SONY CORP.) 17 October 2003 (2003-10-17)<br>paragraphs [0022]-[0027], [0040], fig. 1 | 1-8 |

☐ Further documents are listed in the continuation of Box C.        ☑ See patent family annex.

| | |
|---|---|
| *      Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **22 May 2023** | **30 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

| | International application No. |
|---|---|
| | **PCT/JP2023/009083** |

| Patent document cited in search report | Publication date (day/month/year) | Patent family member(s) | Publication date (day/month/year) |
|---|---|---|---|
| JP 2007-174462 A | 05 July 2007 | (Family: none) | |
| JP 2003-297628 A | 17 October 2003 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004027064 A
- JP 2005045193 A
- JP 2007088121 A
- JP 2007180289 A
- JP 2007250924 A